# EUROPEAN PATENT APPLICATION

(11) **EP 4 770 382 A1**
(43) Date of publication of application: **01.07.2026**
(21) Application number: 25223914.0
(22) Date of filing: 16.12.2025
(51) Int. Cl.: H10K 59/131, H10K 59/40

(54) **DISPLAY DEVICE**

(30) Priority: 30.12.2024 KR 20240200527
(71) Applicant: LG Display Co., Ltd., Seoul, 07336 (KR)
(72) Inventor: RYU, JaeHyun, 10845 Paju-si, Gyeonggi-do (KR)
(74) Representative: Viering, Jentschura & Partner mbB Patent- und Rechtsanwälte

(57) **Abstract**

A display device (100) according to embodiments of this specification comprises: a first power line portion(522) extending from a first non-display area (NDA1) to a display area (DA); a second power line portion(521) electrically connected to the first power line portion(522) through a hole in a first insulating layer(331) and extending from the first non-display area (NDA1) to a bending area (BA); and a third power line portion(523) electrically connected to the second power line portion(521) through hole(CH2) in a buffer layer(351) and a second insulating layer(332), thereby preventing the delamination of the insulating layers.

## Description

### TECHNICAL FIELD

The present disclosure relates to a display device.

### BACKGROUND

As the information society advances, the demand for display devices for displaying images has been increasing in various forms. Recently, various display devices such as liquid crystal display (LCD) devices and organic light-emitting display (OLED) devices have been utilized.

A display device may include a plurality of insulating layers and a plurality of signal lines.

### SUMMARY

Among the plurality of insulating layers, some may become detached from the underlying layer, a phenomenon referred to as delamination. If delamination occurs, the intermediate portion of a signal line may be severed.

According to embodiments of this specification, a metal disposed on the buffer layer is connected to a metal disposed below the buffer layer, thereby preventing delamination of a touch buffer layer.

According to embodiments of this specification, a metal disposed on the buffer layer is connected to a metal disposed below the buffer layer, thereby preventing disconnection of the signal line.

According to embodiments of this specification, a metal disposed on the buffer layer is connected to a metal disposed below the buffer layer, thereby reducing the need for repair processes and accordingly optimizing the manufacturing process.

The objects of the embodiments of this specification are not limited to those explicitly mentioned herein, and additional objects not explicitly stated will be apparent to those skilled in the art from the following description. Various embodiments of the present disclosure provide a display device according to claim 1. Further embodiments are described in the dependent claims.

Embodiments of this specification provide a display device comprising: a substrate including a display area, a first non-display area outside the display area, and a bending area positioned on one side of the first non-display area; a first power line portion disposed on the substrate and extending from the first non-display area to the display area; a first insulating layer disposed on the first power line portion and positioned in the first non-display area; a second power line portion disposed on the first insulating layer, electrically connected to the first power line portion through a hole in the first insulating layer, and extending from the first non-display area to the bending area; a second insulating layer disposed on the second power line portion; a buffer layer disposed on the second insulating layer and positioned in the first non-display area; and a third power line portion positioned in the first non-display area, disposed on the buffer layer, and electrically connected to the second power line portion through holes in the buffer layer and the second insulating layer.

According to embodiments of this specification, a metal disposed on the buffer layer is connected to a metal disposed below the buffer layer, thereby preventing delamination of the touch buffer layer.

According to embodiments of this specification, a metal disposed on the buffer layer is connected to a metal disposed below the buffer layer, thereby preventing disconnection of the signal line.

According to embodiments of this specification, a metal disposed on the buffer layer is connected to a metal disposed below the buffer layer, thereby reducing the need for repair processes and accordingly optimizing the manufacturing process.

The effects of the embodiments of this specification are not limited to those explicitly mentioned above, and additional effects not explicitly stated will be apparent to those skilled in the art based on the description of the claims.

### BRIEF DESCRIPTION OF THE DRAWINGS

The present disclosure will be more fully understood from the following detailed description and the accompanying drawings. The detailed description and drawings are provided for illustrative purposes only and are not intended to limit the scope of the present specification.
FIG. 1 is a perspective view of a display device according to embodiments of this specification.
FIG. 2 is a diagram illustrating an exemplary structure in which a touch screen panel is embedded in the display panel of the display device according to embodiments of this specification.
FIG. 3 is a diagram exemplarily illustrating a bending structure and a line structure in the planar structure of a display panel according to embodiments of this specification.
FIG. 4 is a diagram exemplarily illustrating a cross-sectional structure of a display panel according to embodiments of this specification.
FIG. 5 is an enlarged view of a first portion of the non-display area (NDA) shown in FIG. 3.
FIG. 6 shows cross-sectional views of the C-D region and the E-F region shown in FIG. 5.
FIG. 7 is a plan view of a third portion of FIG. 5.
FIG. 8 and FIG. 9 are plan and cross-sectional views of a first auxiliary reinforcement design area of FIG. 5.

### DETAILED DESCRIPTION

In the following description of examples or embodiments of the present invention, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present invention, detailed descriptions of well-known functions and components incorporated herein will be omitted when it is determined that the description may make the subject matter in some embodiments of the present invention rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present invention. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe non-consecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Various embodiments of the present specification will be described in detail with reference to the accompanying drawings.

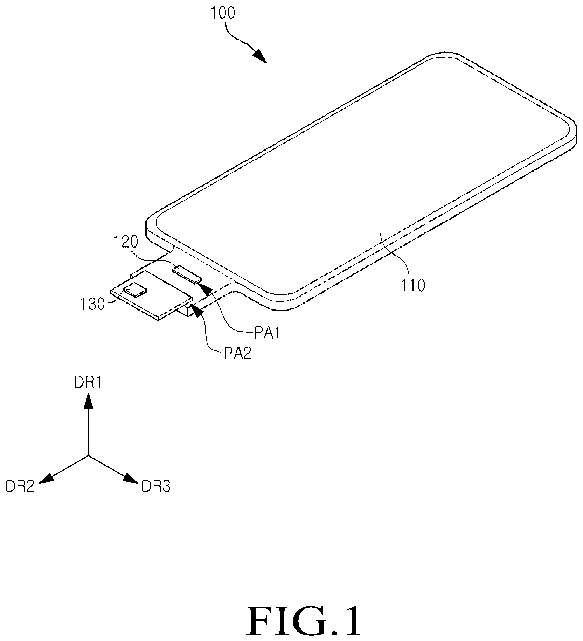

FIG. 1 is a perspective view of a display device 100 according to embodiments of this specification.

Referring to FIG. 1, the display device 100 according to embodiments of this specification may be applied to portable electronic devices such as a mobile phone, a smartphone, a tablet personal computer (PC), a portable communication terminal, an electronic notebook, an e-book, a portable multimedia player (PMP), a navigation system, or an ultra-mobile PC (UMPC).

Alternatively, the display device 100 of this specification may be applied to televisions, laptops, monitors, billboards, wearable devices such as a smartwatch or a watch phone, and other electronic devices. Furthermore, the display device 100 may be applied to automotive displays such as an instrument panel, a center fascia, a center information display (CID) mounted on a dashboard, a room mirror display that replaces a side mirror, or a rear-seat entertainment display installed on the back of the front seat.

The display device 100 may be a display device such as an organic light-emitting diode (OLED) display, a quantum-dot light-emitting display that includes a quantum-dot light-emitting layer, an inorganic light-emitting display that includes an inorganic semiconductor, or a micro light-emitting diode (micro LED) display. The following description focuses on an example in which the display device 100 is an OLED display, but this specification is not limited thereto.

Referring to FIG. 1, the display device 100 according to embodiments of this specification may include a display panel 110 and a display driving circuit as components for displaying an image. The display driving circuit may be a circuit that drives the display panel 110 and may include a data driving circuit, a gate driving circuit, and a controller, but embodiments of this specification are not limited thereto.

The display device 100 of this specification may include the display panel 110, a first pad area PA1, and a second pad area PA2. The first pad area PA1 and the second pad area PA2 may be regions where a driving circuit (such as a data driving circuit or a gate driving circuit) is connected or bonded.

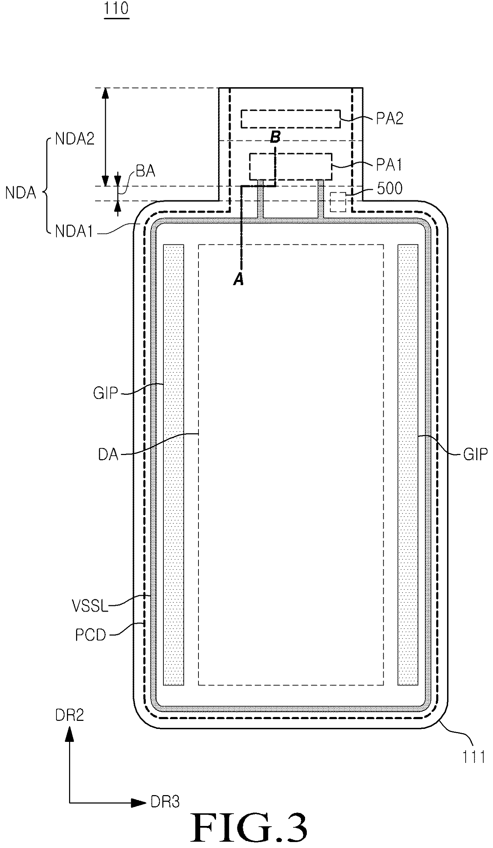

Referring to FIG. 1, the first pad area PA1 and the second pad area PA2 may be positioned on the display panel 110. Referring to FIG. 1 and FIG. 3, the first driver 120 may be disposed in the first pad area PA1. Referring to FIG. 1 and FIG. 3, one end of a circuit portion where the second driver 130 is disposed may be connected to the second pad area PA2 of the display panel 110.

Referring to FIG. 1, the pad areas PA1 and PA2 are illustrated as two, but there may be more than two pad areas. For example, a pad area may be a region positioned at the outermost edge of a substrate. A pad area may be a region where a chip is mounted. A pad area may also be a region where a pad of another substrate or another film is connected to a pad of the substrate of the display panel 100.

The display panel 110 may have a rectangular planar shape with a short side in a first direction and a long side in a second direction intersecting the first direction. A corner where the short side and the long side meet may be rounded with a predetermined curvature or formed at a right angle. The planar shape of the display panel 110 is not limited to a rectangle and may be formed as another polygonal shape, a circular shape, or an elliptical shape. The display panel 110 may be formed as a flat panel but is not limited thereto. For example, the display panel 110 may include curved portions formed at the left and right edges with a fixed or varying curvature. Additionally, the display panel 110 may be configured to be flexible so that it can be bent, flexed, folded, or rolled.

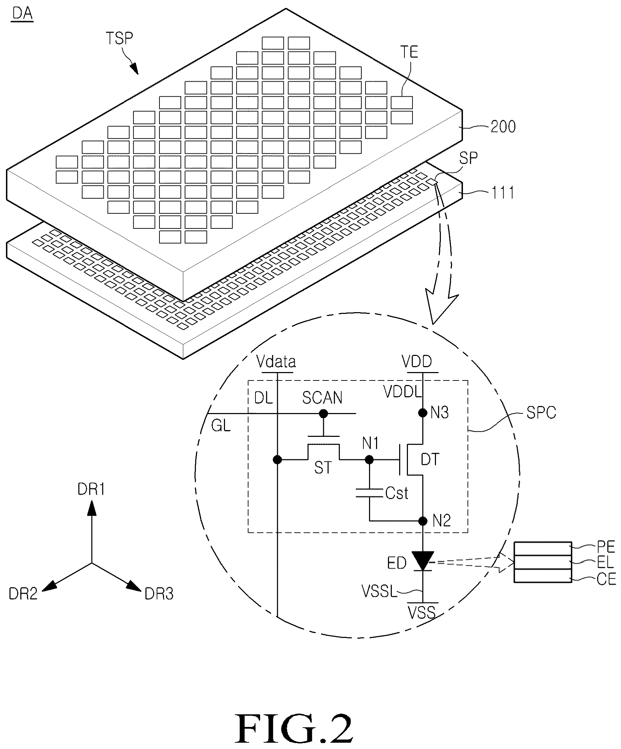

FIG. 2 is a diagram illustrating an exemplary structure in which a touch screen panel is embedded in the display panel 110 of the display device 100 according to embodiments of this specification.

Referring to FIG. 2, the display panel according to embodiments of this specification may include a substrate 111 disposed on a plurality of sub-pixels SP and an encapsulation layer 200 disposed on the substrate 111. The encapsulation layer 200 may also be referred to as an encapsulation substrate or an encapsulation portion.

The display device 100 according to embodiments of this specification may be a self-emissive display device which emits light by itself, but embodiments of this specification are not limited thereto. When the display device 100 according to embodiments of this specification is a self-emissive display device, each of the plurality of sub-pixels SP disposed on the substrate 111 may include a light-emitting device ED and a sub-pixel circuit SPC for driving the light-emitting device ED.

The sub-pixel circuit SPC may include a plurality of transistors and at least one capacitor for driving the light-emitting device ED, but embodiments of this specification are not limited thereto. In this specification, the sub-pixel circuit SPC may drive the light-emitting device ED by supplying a predetermined driving current to the light-emitting device ED at a set timing. The light-emitting device ED may be driven by the driving current and emit light.

A variety of signal lines for driving the plurality of sub-pixels SP may be arranged on the substrate 111 of the display panel 110. For example, various signal lines may include a plurality of data lines DL for transmitting data signals (also referred to as data voltages or image signals) to the plurality of sub-pixels SP and a plurality of gate lines GL for transmitting gate signals (also referred to as scan signals) to the plurality of sub-pixels SP.

For example, the plurality of data lines DL and the plurality of gate lines GL may intersect each other. Each of the plurality of gate lines GL may be arranged to extend in a first direction (e.g., a row direction or a column direction). Each of the plurality of data lines DL may be arranged to extend in a second direction different from the first direction (e.g., a column direction or a row direction).

In embodiments of this specification, for example, the first direction may be a row direction, and the second direction may be a column direction. In another example, the first direction may be a column direction, and the second direction may be a row direction. The row direction and the column direction may be relative directions. For instance, depending on the viewpoint, the column direction may be considered the row direction, and vice versa. In the following description, for the convenience of explanation, the plurality of data lines DL are illustrated as being arranged in the column direction, and the plurality of gate lines GL are illustrated as being arranged in the row direction. However, embodiments of this specification are not limited thereto. The angle between the first direction and the second direction may be 90 degrees (perpendicular) or another angle.

The sub-pixel circuit SPC may be controlled by a data driving circuit. The data driving circuit may be a circuit for driving the plurality of data lines DL and may output data signals to the plurality of data lines DL. The data driving circuit may receive digital image data from a controller, convert the received image data into analog data signals (also referred to as data voltages), and output the analog data signals to the plurality of data lines DL. The data driving circuit may be connected outside the display area of the display panel 110, but in another example, it may be disposed within the display area of the display panel 110.

The sub-pixel circuit SPC may be controlled by a gate driving circuit. The gate driving circuit may be a circuit for driving the plurality of gate lines GL and may output gate signals to the plurality of gate lines GL. The gate driving circuit may receive a first gate voltage corresponding to a turn-on voltage (also referred to as a turn-on level voltage) and a second gate voltage corresponding to a turn-off voltage (also referred to as a turn-off level voltage), along with various gate driving control signals (GCS). The gate driving circuit may generate gate signals that include a period having the first gate voltage and a period having the second gate voltage for a certain period of time (e.g., one frame period) and may supply the generated gate signals to the plurality of gate lines GL. In one example, the turn-on level voltage may be a high-level voltage, and the turn-off level voltage may be a low-level voltage. In another example, the turn-on level voltage may be a low-level voltage, and the turn-off level voltage may be a high-level voltage.

In the display device 100 according to embodiments of this specification, the gate driving circuit may be embedded in the display panel 110 as a gate-in-panel (GIP) type, but embodiments of this specification are not limited thereto. For example, the gate driving circuit may be arranged in the GIP type shown in FIG. 3.

When the gate driving circuit is disposed in the display area DA of the display panel 110, it may overlap vertically with the sub-pixels SP arranged in the display area DA. For example, the gate driving circuit may be vertically overlapped with the light-emitting devices and transistors included in the sub-pixels SP arranged in the display area DA. The gate driving circuit may include a plurality of transistors. However, The gate driving circuit may be vertically overlapped with a plurality of light-emitting devices and a plurality of transistors included in the plurality of sub-pixels SP arranged in the display area DA.

The plurality of transistors included in the gate driving circuit may each include an active layer comprising a first semiconductor material, and the plurality of transistors included in the sub-pixels SP may each include an active layer comprising a second semiconductor material. In one example, the first semiconductor material and the second semiconductor material may be substantially the same. In another example, the first semiconductor material and the second semiconductor material may be different from each other. For example, the first semiconductor material may be a silicon-based semiconductor material, such as low-temperature polycrystalline silicon (LTPS), and the second semiconductor material may be an oxide semiconductor material. The active layer may be a semiconductor layer but is not limited thereto.

The controller is a device for controlling the data driving circuit and the gate driving circuit and may control the driving timing of the plurality of data lines DL and the plurality of gate lines GL. The controller may receive input image data from a host system and supply image data to the data driving circuit based on the received input image data. The controller may be implemented as a separate component from the data driving circuit or may be integrated with the data driving circuit as an integrated circuit. The controller may be a timing controller (TCON) used in display technology, a control device that includes a timing controller and performs additional control functions, a control device separate from the timing controller, or a circuit within a control device.

The plurality of transistors may include a driving transistor DT for driving the light-emitting device ED and a scan transistor ST that is turned on or off according to a scan signal SCAN.

The driving transistor DT may supply a driving current to the light-emitting device ED. The scan transistor ST may be configured to control the electrical state of a corresponding node in the sub-pixel circuit SPC or to control the state or operation of the driving transistor DT. At least one capacitor may include a storage capacitor Cst for maintaining a certain voltage during a frame period.

For the operation of the sub-pixel SP, a data signal Vdata, which is an image signal, and a scan signal SCAN, which is a type of gate signal, may be applied to the sub-pixel SP. Additionally, a common driving signal, including a driving voltage VDD and a reference voltage VSS, may be applied to the sub-pixel SP for its operation. The light-emitting device ED may include a pixel electrode PE, an intermediate layer EL, and a common electrode CE. The intermediate layer EL may be disposed between the pixel electrode PE and the common electrode CE. For example, the pixel electrode PE may be an electrode disposed in each sub-pixel SP, and the common electrode CE may be an electrode commonly disposed for the plurality of sub-pixels SP. In one example, the pixel electrode PE may be an anode, and the common electrode CE may be a cathode. The common electrode CE may be electrically connected to a reference voltage line VSSL. A reference voltage VSS, which is a type of common voltage, may be applied to the common electrode CE through the reference voltage line VSSL. The pixel electrode PE may be electrically connected directly or indirectly (via another transistor) to the second node N2 of the driving transistor DT in each sub-pixel SP.

The driving transistor DT may be a transistor for supplying a driving current to the light-emitting device ED. The driving transistor DT may be connected between a driving voltage line VDDL and the light-emitting device ED.

The driving transistor DT may include a first node N1, a second node N2, and a third node N3. The first node N1 may receive the data signal Vdata, the second node N2 may be electrically connected to the light-emitting device ED, and the third node N3 may receive a driving voltage VDD, which is another type of common voltage, from the driving voltage line VDDL. The driving transistor DT may be connected across the second node N2 and the third node N3. In this specification, the driving voltage VDD may also be referred to as a second common voltage, a high-potential power supply voltage, or a high-potential voltage, and the driving voltage line VDDL may also be referred to as a second common voltage line, a low-potential power supply voltage line, or a low-potential voltage line.

In the driving transistor DT, the first node N1 may be a gate node, the second node N2 may be a source node or a drain node, and the third node N3 may be a drain node or a source node. In the following description, for the convenience of explanation, an example is given where the first node N1 is a gate node, the second node N2 is a source node, and the third node N3 is a drain node. However, the embodiments of this specification are not limited thereto.

The scan transistor ST included in the sub-pixel circuit SPC illustrated in FIG. 2 may be a switching transistor for transmitting the data signal Vdata, which is an image signal, to the second node N2, which is a gate note of the driving transistor DT. The scan transistor ST is controlled to turn on and off by a scan signal SCAN, which is a type of gate signal applied through a scan line GL, which is a type of gate line GL, and may control the electrical connection between the second node N2 of the driving transistor DT and the data line DL.

The storage capacitor Cst may be electrically connected between the first node N1 and the second node N2 of the driving transistor DT. The storage capacitor Cst may include at least one capacitor electrode electrically connected to the first node N1 of the driving transistor DT or corresponding to the first node N1, and at least one capacitor electrode electrically connected to the second node N2 of the driving transistor DT or corresponding to the second node N2.

The driving transistor DT and the scan transistor ST may each be an n-type transistor or a p-type transistor; however, the embodiments of this specification are not limited thereto. For example, one of the driving transistor DT and the scan transistor ST may be either an n-type transistor or a p-type transistor.

As illustrated in FIG. 2, the sub-pixel circuit SPC may have a 2T (two-transistor) 1C (one-capacitor) structure including two transistors DT and ST and one capacitor Cst. In some cases, the sub-pixel circuit SPC may further include at least one additional transistor or at least one additional capacitor. For example, the sub-pixel circuit SPC may have a 3T1C structure including three transistors and one capacitor. In another example, the sub-pixel circuit SPC may have an 8T1C structure including eight transistors and one capacitor. In yet another example, the sub-pixel circuit SPC may have a 6T2C structure including six transistors and two capacitors. In still another example, the sub-pixel circuit SPC may have a 7T1C structure including seven transistors and one capacitor. The embodiments of this specification are not limited thereto. Depending on the structure of the sub-pixel circuit SPC, the type and number of gate signals and gate lines supplied to the sub-pixel SP may vary. Additionally, depending on the structure of the sub-pixel circuit SPC, the type and number of common driving signals supplied to the sub-pixel SP may vary.

Since the circuit elements in each sub-pixel SP, such as the light-emitting device ED implemented using an organic light-emitting diode OLED, are vulnerable to external moisture or oxygen, an encapsulation layer 200 may be disposed in the display panel 110. The encapsulation layer 200 may prevent external moisture or oxygen from penetrating the circuit elements, such as the light-emitting device ED.

Referring to FIG. 2, in order to provide a touch-sensing function, the display device 100 according to the embodiments of this specification may include a touch screen panel TSP formed on the encapsulation layer 200 and embedded in the display panel 110. That is, in the display device 100, multiple touch electrodes TE forming the touch screen panel TSP may be disposed on the encapsulation layer 200 to constitute the display panel 110.

The display device 100 according to the embodiments of this specification may provide not only an image display function but also a touch-sensing function for detecting whether a touch has occurred by a touch object, such as a finger or a pen, or detecting a touch position.

For example, when the encapsulation layer 200 includes multiple layers, the touch electrode TE may be disposed between any first encapsulation layer and a second encapsulation layer; however, the embodiments of this specification are not limited thereto.

The display device 100 may sense touch using a capacitance-based touch-sensing method, such as a mutual capacitance method or a self-capacitance method.

FIG. 3 is a diagram illustrating an example of the bending structure and line structure in the planar structure of the display panel 110 according to the embodiments of this specification.

Referring to FIG. 3, the substrate 111 of the display panel 110 according to the embodiments of this specification may include a display area DA and a non-display area NDA. The display area DA and the non-display area NDA may be referred to as regions of the display panel 110.

All lines and electrodes are formed on the substrate 111. In the display device 100 according to the embodiments of this specification, the substrate 111 may be a flexible substrate capable of bending. In this specification, "bending" may have the same meaning as "folding" or "flexible."

The non-display area NDA is an area where no image is displayed and may refer to the area excluding the display area DA. No sub-pixels SP are arranged in the non-display area NDA. However, at least one dummy sub-pixel that is not directly involved in image display may be disposed in the non-display area NDA. The non-display area NDA may include a first non-display area NDA1, a bending area BA, and a second non-display area NDA2.

The first non-display area NDA1 may be positioned around the display area DA and may be the area closest to the display area DA among the first non-display area NDA1, the bending area BA, and the second non-display area NDA2.

The second non-display area NDA2 may include pad areas PA1 and PA2, where various pads are arranged, and may be the area farthest from the display area DA among the first non-display area NDA1, the bending area BA, and the second non-display area NDA2.

The bending area BA is an area where the substrate 111 is bent and may be positioned between the first non-display area NDA1 and the second non-display area NDA2.

The substrate 111 may include the display area DA, where an image is displayed, and the non-display area NDA, which is an outer area of the display area DA. A plurality of sub-pixels SP may be arranged in the display area DA. The non-display area NDA may include a Gate In Panel GIP area where a GIP-type gate driving circuit is formed, a bending area BA and a second non-display area NDA2, where various lines pass through and the data driving circuit is electrically connected.

For example, the GIP area may be positioned at the left and/or right outer edges of the display area DA. The non-display area NDA may be positioned at the upper or lower outer edges of the display area DA. The bending area BA may be a more outer area than the second non-display area NDA2 and may be electrically connected to a printed circuit board PCB.

As described above, the substrate 111 may include a bending area BA that is bent and folded, and the bending area BA may be folded and positioned on the lower surface of the unfolded portion. The bending area BA is a part of the non-display area NDA and may be positioned between the driving circuit area, where the data driving circuit is electrically connected, and the display area DA.

A plurality of driving voltage lines VDDL for supplying a driving voltage VDD to the sub-pixels SP and at least one reference voltage line VSSL for applying a reference voltage VSS to the common electrode CE of the light-emitting device ED in each sub-pixel SP may be further disposed on the substrate 111.

The reference voltage line VSSL may be disposed in the non-display area NDA to surround the outer region of the display area DA for the efficient transmission of the reference voltage VSS. In addition, the reference voltage line VSSL may pass through the bending area BA and be electrically connected to the data driving circuit in the driving circuit area or to a printed circuit board PCB.

A crack prevention pattern PCD may be formed on the substrate 111. The crack prevention pattern PCD may be formed outside the reference voltage line VSSL in the non-display area NDA, but embodiments of the present disclosure is not limited thereto.

For example, the crack prevention pattern PCD is a pattern for preventing cracks in the lines passing through the substrate 111. It may be formed in a zigzag pattern, but is not limited thereto.

For example, among the signal lines passing through the bending area BA, some may develop cracks (electrical open state) or become short-circuited with adjacent signal lines when the bending area BA is bent. In such cases, if a signal line develops a crack (open state) or a short circuit, accurate signal transmission may be disrupted, causing issues in display operation and resulting in improper image display. Consequently, image quality may significantly degrade. To prevent this, the crack prevention pattern PCD may be included, but is not limited thereto.

The aforementioned display panel 110 bends the bending area BA, where the data driving circuit is connected, using the substrate 111, causing a portion of the substrate 111 to be folded backward. The folded bending area BA becomes a non-visible portion where an image cannot be displayed from the front. Accordingly, by utilizing the bending structure and the wiring layout as shown in FIG. 3, the bezel size of the display device 100 can be significantly reduced.

The pad area PA1, PA2 may include a first pad area PA1 and a second pad area PA2. The pad areas PA1, PA2 may be positioned in the second non-display area NDA2. The first pad area PA1 and the second pad area PA2 shown in FIG. 3 may be the same as those shown in FIG. 1, and the size and position of the pad areas PA1, PA2 may vary depending on the design of the display panel 110.

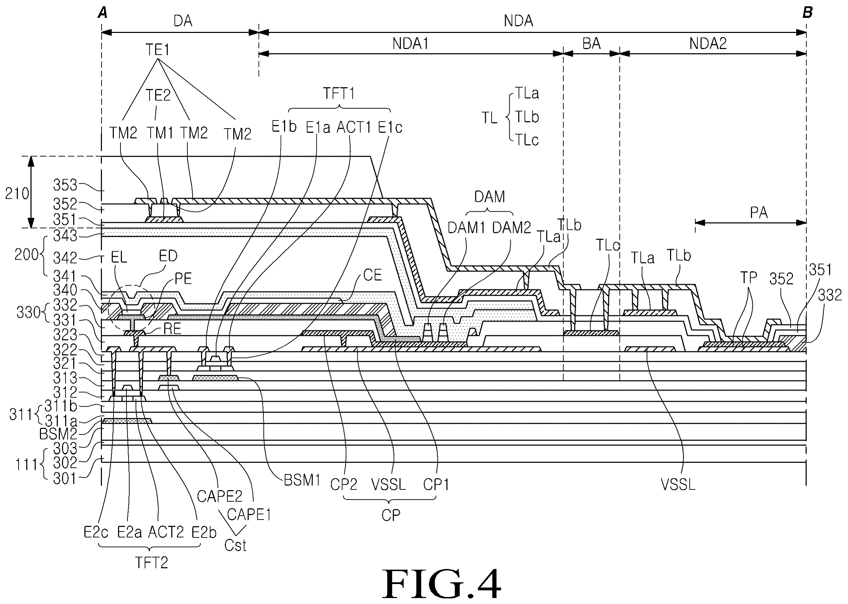

FIG. 4 is a diagram illustrating an example of the cross-sectional structure of the display panel 110 shown in FIG. 3, according to embodiments of this specification.

Referring to FIG. 4, the display panel 110 according to embodiments of this specification may include a substrate 111, a transistor portion, a light-emitting device portion, and an encapsulation portion, but is not limited thereto.

The substrate 111 may be a single-layer or multi-layer structure. When the substrate 111 is a multi-layer structure, it may include a first substrate 301, an intermediate substrate 302, and a second substrate 303. The intermediate substrate 302 may be positioned between the first substrate 301 and the second substrate 303. For example, each of the first substrate 301 and the second substrate 303 may be a polyimide (PI) layer, but embodiments of the present specification are not limited thereto. The intermediate substrate 302 may be an inorganic insulating layer, but embodiments of the present specification are not limited thereto. When charge accumulates in the first substrate 301, which is a polyimide layer, the intermediate substrate 302 can prevent the charge from affecting the transistors disposed on the second substrate 303, which is also a polyimide layer.

Additionally, the intermediate substrate 302 may prevent moisture from penetrating through the first substrate 301 to the upper portion. For example, the intermediate substrate 302 may be a single layer or multiple layers of silicon nitride (SiNx) or silicon oxide (SiOx) and may also be formed as a dual-layer structure of silicon dioxide (SiO2) and silicon nitride (SiNx), but is not limited thereto.

The transistor portion may include insulating layers 311, 312, 313, 321, 322, and 323 disposed on the substrate 111, thin-film transistors TFT1 and TFT2, a storage capacitor Cst, and various electrodes and signal lines.

The thin-film transistors TFT1 and TFT2 included in the transistor portion may include a first thin-film transistor TFT1 (LTPS) and a second thin-film transistor TFT2 (Oxide).

The first thin-film transistor TFT1 (LTPS) may include a first active layer ACT1, a first electrode E1a, a second electrode E1b, and a third electrode E1c.

The first electrode E1a may be a gate electrode, the second electrode E1b may be a source electrode or a drain electrode, and the third electrode E1c may be a drain electrode or a source electrode. Hereinafter, for convenience of description, the first electrode E1a is referred to as the first gate electrode E1a, the second electrode E1b as the first source electrode E1b, and the third electrode E1c as the first drain electrode E1c. However, the embodiments of the present disclosure are not limited thereto.

The first active layer ACT1 may include a first semiconductor material. For example, the first semiconductor material may include an oxide semiconductor, amorphous silicon, polysilicon, or low-temperature polysilicon (LTPS), but the embodiments of the present disclosure are not limited thereto. The first thin-film transistor TFT1 (LTPS) may be implemented as a p-channel transistor or an n-channel transistor, but the embodiments of the present disclosure are not limited thereto.

The second thin-film transistor TFT2 (Oxide) may include a second active layer ACT2, a fourth electrode E2a, a fifth electrode E2b, and a sixth electrode E2c.

The fourth electrode E2a may be a gate electrode, the fifth electrode E2b may be a source electrode or a drain electrode, and the sixth electrode E2c may be a drain electrode or a source electrode. Hereinafter, for convenience of description, the fourth electrode E2a is referred to as the second gate electrode E2a, the fifth electrode E2b as the second source electrode E2b, and the sixth electrode E2c as the second drain electrode E2c. However, the embodiments of the present disclosure are not limited thereto.

The second active layer ACT2 may include a second semiconductor material. For example, the second semiconductor material may include an oxide semiconductor, amorphous silicon, polysilicon, or low-temperature polysilicon (LTPS), but the embodiments of the present disclosure are not limited thereto. The second thin-film transistor TFT2 (Oxide) may be implemented as a p-channel transistor or an n-channel transistor, but the embodiments of the present disclosure are not limited thereto.

The types of semiconductor materials used in the first active layer ACT1 of the first thin-film transistor TFT1 (LTPS) and the second active layer ACT2 of the second thin-film transistor TFT2 (Oxide) may be as follows:

In one example, both the first active layer ACT1 of the first thin-film transistor TFT1 (LTPS) and the second active layer ACT2 of the second thin-film transistor TFT2 (Oxide) may include an oxide semiconductor material. In another example, both the first active layer ACT1 of the first thin-film transistor TFT1 (LTPS) and the second active layer ACT2 of the second thin-film transistor TFT2 (OXIDE) may include a low-temperature polysilicon semiconductor material. In yet another example, the first active layer ACT1 of the first thin-film transistor TFT1 (LTPS) may include a low-temperature polysilicon semiconductor material, while the second active layer ACT2 of the second thin-film transistor TFT2 (Oxide) may include an oxide semiconductor material. Conversely, the first active layer ACT1 of the first thin-film transistor TFT1 (LTPS) may include an oxide semiconductor material, while the second active layer ACT2 of the second thin-film transistor TFT2 (Oxide) may include a low-temperature polysilicon semiconductor material.

The plurality of transistors may be implemented as follows: In one example, all transistors in each sub-pixel SP may be implemented as the first thin-film transistor TFT1 (LTPS). In another example, all transistors in each sub-pixel SP may be implemented as the second thin-film transistor TFT2 (Oxide). In yet another example, some of the transistors in each sub-pixel SP may be implemented as the first thin-film transistor TFT1 (LTPS), while the remaining transistors may be implemented as the second thin-film transistor TFT2 (OXIDE). That is, each sub-pixel SP may include at least one first thin-film transistor TFT1 (LTPS) and at least one second thin-film transistor TFT2 (Oxide).

When some of the transistors in each sub-pixel SP are implemented as the first thin-film transistor TFT1 (LTPS), and the remaining transistors are implemented as the second thin-film transistor TFT2 (Oxide), the following configurations may be possible: In one example, in each sub-pixel SP, the driving transistor DT may be implemented as the second thin-film transistor TFT2 (Oxide), while the transistors other than the driving transistor DT (e.g., the scan transistor ST, emission control transistor, etc.) may be implemented as the first thin-film transistor TFT1 (LTPS). Alternatively, the configuration may be reversed.

In FIG. 4, the second thin-film transistor TFT2 (Oxide), which is connected to the pixel electrode PE of the light-emitting device ED, may function as a driving transistor DT or another transistor depending on the configuration of the sub-pixel circuit SPC. For example, in FIG. 4, the second thin-film transistor TFT2 (Oxide), which is connected to the pixel electrode PE of the light-emitting device ED, may be an emission control transistor connected between the driving transistor DT and the light-emitting device ED.

The second active layer ACT2 of the second thin-film transistor TFT2 (Oxide) may be positioned higher than the first active layer ACT1 of the first thin-film transistor TFT1 (LTPS) relative to the substrate 111.

A first buffer layer 311 may be disposed below the first active layer ACT1 of the first thin-film transistor TFT1 (LTPS), and a second buffer layer 321 may be disposed below the second active layer ACT2 of the second thin-film transistor TFT2 (Oxide). For example, the first active layer ACT1 of the first thin-film transistor TFT1 (LTPS) may be positioned on the first buffer layer 311, and the second active layer ACT2 of the second thin-film transistor TFT2 (Oxide) may be positioned on the second buffer layer 321. The second buffer layer 321 may be positioned higher than the first buffer layer 311.

The storage capacitor Cst may be disposed within various metal layers of the display panel 110. For example, the storage capacitor Cst may include a first capacitor electrode CAPE1 and a second capacitor electrode CAPE2.

The light-emitting device portion may include a plurality of light-emitting devices ED disposed on a planarization layer 330. Each of the plurality of light-emitting devices ED may include a pixel electrode PE, an intermediate layer EL, and a common electrode CE.

The encapsulation portion may include an encapsulation layer 200 disposed over the plurality of light-emitting devices ED. The encapsulation layer 200 may be a single layer or a multi-layer structure; however, the embodiments of the present disclosure are not limited thereto. In addition to the encapsulation layer 200, the encapsulation portion may further include at least one dam (DAM) to prevent excess material from overflowing during the formation of the encapsulation layer 200. In particular, when the second encapsulation layer 342 included in the encapsulation layer 200 is an organic encapsulation layer made of an organic material, the dam (DAM) may prevent the organic material from overflowing.

Hereinafter, with reference to FIG. 4, the structure or vertical configuration of the display panel 110 according to the embodiments of the present disclosure will be described in more detail.

Referring to FIG. 4, a first buffer layer 311 may be disposed on the substrate 111. The first buffer layer 311 may be a single layer or a multi-layer structure; however, the embodiments of the present disclosure are not limited thereto. When the first buffer layer 311 is a multi-layer structure, it may include a lower buffer layer 311a and an upper buffer layer 311b.

The first active layer ACT1 of the first thin-film transistor TFT1 (LTPS) may be disposed on the first buffer layer 311. The first active layer ACT1 may include a channel region where a channel is formed, a source connection area on one side of the channel area, and a drain connection area on the other side of the channel area.

A first gate insulating layer 312 may be disposed on the first active layer ACT1 of the first thin-film transistor TFT1 (LTPS). The first gate electrode E1a of the first thin-film transistor TFT1 (LTPS) may be disposed on the first gate insulating layer 312. A first interlayer insulating layer 313 may be disposed on the first gate electrode E1a of the first thin-film transistor TFT1 (LTPS). Here, the metal layer in which the first gate electrode E1a of the first thin-film transistor TFT1 (LTPS) is disposed may be referred to as a first gate metal layer.

The second buffer layer 321 may be disposed on the first interlayer insulating layer 313. The second active layer ACT2 of the second thin-film transistor TFT2 (Oxide) may be disposed on the second buffer layer 321. The second active layer ACT2 may include a channel area where a channel is formed, a source connection area on one side of the channel area, and a drain connection area on the other side of the channel area.

The second gate insulating layer 322 may be disposed on the second active layer ACT2 of the second thin-film transistor TFT2 (Oxide). The second gate electrode E2a of the second thin-film transistor TFT2 (Oxide) may be disposed thereon. The second interlayer insulating layer 323 may be disposed on the second gate electrode E2a. Here, the second gate electrode E2a of the second thin-film transistor TFT2 (Oxide) may be referred to as a second gate metal layer.

The first source electrode E1b and the first drain electrode E1c of the first thin-film transistor TFT1 (LTPS) and the second source electrode E2b and the second drain electrode E2c of the second thin-film transistor TFT2 (Oxide) may be disposed on the second interlayer insulating layer 323.

The first source electrode E1b and the first drain electrode E1c of the first thin-film transistor TFT1 (LTPS) may be connected to the source connection area and the drain connection area of the first active layer ACT1 through holes in the second interlayer insulating layer 323, the second gate insulating layer 322, the second buffer layer 321, the first interlayer insulating layer 313, and the first gate insulating layer 312.

The second source electrode E2b and the second drain electrode E2c of the second thin-film transistor TFT2 (Oxide) may be connected to the source connection area and the drain connection area of the second active layer ACT2 through holes in the second interlayer insulating layer 323 and the second gate insulating layer 322.

The first source electrode E1b and the first drain electrode E1c of the first thin-film transistor TFT1 (LTPS), as well as the second source electrode E2b and the second drain electrode E2c of the second thin-film transistor TFT2 (Oxide), may include a first source-drain metal and may be disposed within the first source-drain metal layer.

Referring to FIG. 4, for example, the storage capacitor Cst may be formed by the first capacitor electrode CAPE1 and the second capacitor electrode CAPE2. In some cases, the storage capacitor Cst may be formed by three or more capacitor electrodes and may be configured in a parallel connection of two or more capacitors. Each of the first capacitor electrode CAPE1 and the second capacitor electrode CAPE2 may be disposed within various metal layers in the display panel 110. For example, the first capacitor electrode CAPE1 may include the same first gate metal as the first gate electrode E1a of the first thin-film transistor TFT1 (LTPS) on the first gate insulating layer 312 and may be disposed within the first gate metal layer. However, embodiments of this specification are not limited thereto. For example, the second capacitor electrode CAPE2 may be disposed on the first interlayer insulating layer 313.

The second source electrode E2b of the second thin-film transistor TFT2 (Oxide) may be electrically connected to the second capacitor electrode CAPE2 through holes in the second interlayer insulating layer 323, the second gate insulating layer 322, and the second buffer layer 321.

For example, when the sub-pixel SP is configured as shown in FIG. 2, the first thin-film transistor TFT1 (LTPS) may be the scan transistor ST in FIG. 2, and the second thin-film transistor TFT2 (Oxide) may be the driving transistor DT in FIG. 2.

Referring to FIG. 4, the transistor portion may further include a first shield pattern BSM1 disposed on the substrate 111. The first shield pattern BSM1 may overlap with the first active layer ACT1 of the first thin-film transistor TFT1 (LTPS). The first shield pattern BSM1 may be disposed below the first active layer ACT1 of the first thin-film transistor TFT1 (LTPS). For example, the first shield pattern BSM1 may be disposed between the substrate 111 and the first buffer layer 311, or it may be positioned between the lower buffer layer 311a and the upper buffer layer 311b.

The transistor portion may further include a second shield pattern BSM2 disposed on the substrate 111. The second shield pattern BSM2 may overlap with the second active layer ACT2 of the second thin-film transistor TFT2 (Oxide). The second shield pattern BSM2 may be disposed below the second active layer ACT2 of the second thin-film transistor TFT2 (Oxide). For example, the second shield pattern BSM2 may be disposed within a metal layer between the first interlayer insulating layer 313 and the second buffer layer 321. The second shield pattern BSM2 may be disposed within the same metal layer as the second capacitor electrode CAPE2. However, embodiments of this specification are not limited thereto. In another example, the second shield pattern BSM2 may be disposed within the same first gate metal layer as the first gate electrode E1a of the first thin-film transistor TFT1 (LTPS).

The planarization layer 330 may be disposed on the first thin-film transistor TFT1 (LTPS) and the second thin-film transistor TFT2 (Oxide) and may be disposed below the light-emitting device ED. The planarization layer 330 may be an organic insulating layer including an organic insulating material.

In one example, the planarization layer 330 may be formed as a single layer. In another example, the planarization layer 330 may include two layers. The planarization layer 330 may include a first planarization layer 331 and a second planarization layer 332. In another example, the planarization layer 330 may include three or more layers. However, embodiments of this specification are not limited thereto.

Referring to FIG. 4, the first planarization layer 331 may be disposed on the first source electrode E1b and the first drain electrode E1c of the first thin-film transistor TFT1 (LTPS) and on the second source electrode E2b and the second drain electrode E2c of the second thin-film transistor TFT2 (Oxide). For example, the first planarization layer 331 may be disposed on the first thin-film transistor TFT1 (LTPS) and the second thin-film transistor TFT2 (Oxide). The first planarization layer 331 may be disposed to cover both the first thin-film transistor TFT1 (LTPS) and the second thin-film transistor TFT2 (Oxide).

Referring to FIG. 4, the connection electrode RE may be disposed on the first planarization layer 331. The connection electrode RE may electrically connect the second source electrode E2b of the second thin-film transistor TFT2 (Oxide) and the pixel electrode PE.

The connection electrode RE may be electrically connected to the second source electrode E2b of the second thin-film transistor TFT2 (Oxide) through a hole in the first planarization layer 331. The second source electrode E2b of the second thin-film transistor TFT2 (Oxide) may be electrically connected to the second capacitor electrode CAPE2 of the storage capacitor Cst.

The connection electrode RE may be disposed within a second source-drain metal layer on the first planarization layer 331 and may include a second source-drain metal. The second planarization layer 332 may be disposed on the connection electrode RE.

Referring to FIG. 4, the light-emitting device portion may be disposed on the second planarization layer 332. The light-emitting device ED may be formed on the second planarization layer 332. The light-emitting device ED may include the pixel electrode PE, the intermediate layer EL, and the common electrode CE. The emission area of the light-emitting device ED may be formed in a region where the pixel electrode PE, the intermediate layer EL, and the common electrode CE overlap and make contact.

The pixel electrode PE may be disposed on the second planarization layer 332. The pixel electrode PE may be electrically connected to the connection electrode RE through a hole in the second planarization layer 332.

The bank 340 may be disposed on the pixel electrode PE. The opening of the bank 340 may expose a portion of the pixel electrode PE to form an emission area. The opening of the bank 340 may overlap with a portion of the pixel electrode PE. For example, the bank 340 may be composed of a material including a black pigment, or an organic material such as benzocyclobutene resin, polyimide resin, acrylic resin, or a photosensitive polymer. However, embodiments of this specification are not limited thereto. If the bank 340 is composed of a material including a black pigment or a black dye, it may be a black bank. When the bank 340 is composed of a material including a black pigment or a black dye, it may block external light or prevent light from being reflected externally, thereby improving the luminance of the display device 100.

The intermediate layer EL of the light-emitting device ED may be disposed on a portion of the pixel electrode PE and on the bank 340. The common electrode CE may be disposed on the intermediate layer EL.

Referring to FIG. 4, the encapsulation portion may be disposed on the light-emitting device portion and may be positioned on the common electrode CE. The encapsulation portion may include an encapsulation layer 200 formed on the common electrode CE. The encapsulation layer 200 may prevent moisture or oxygen from penetrating the light-emitting device ED. For example, the encapsulation layer 200 may prevent moisture or oxygen from penetrating the organic material included in the intermediate layer EL of the light-emitting device ED.

The encapsulation layer 200 may be formed as a single layer or as multiple layers; however, embodiments of the present disclosure are not limited thereto. For example, the encapsulation layer 200 may include a first encapsulation layer 341, a second encapsulation layer 342, and a third encapsulation layer 343, but the embodiments of the present disclosure are not limited thereto. The first encapsulation layer 341 and the third encapsulation layer 343 may include inorganic encapsulation layers, and the second encapsulation layer 342 may include an organic encapsulation layer; however, the embodiments of the present disclosure are not limited thereto.

The display panel 110 according to embodiments of the present disclosure may also incorporate a touch sensor. In this case, the display panel 110 may include a touch sensor layer (210) that is disposed on the encapsulation layer 200 and has a touch sensor formed thereon.

Referring to FIG. 4, the touch sensor layer 210 may include a plurality of touch electrodes TE corresponding to the touch sensor and may include at least one touch metal layer for forming the plurality of touch electrodes TE.

For example, to form the plurality of touch electrodes TE, the touch sensor layer 210 may include a first touch metal layer in which a plurality of first touch metals TM1 are disposed and a second touch metal layer in which a plurality of second touch metals TM2 are disposed. The first touch metals TM1 and the second touch metals TM2 may refer to components or materials included in the components. In this case, the touch sensor layer 210 may further include a touch interlayer insulating layer 352 disposed between the first touch metal layer and the second touch metal layer. For example, one of the first and second touch metal layers may be a sensor metal layer, and the other may be a bridge metal layer.

For example, the first touch metal layer may be a bridge metal layer, and the second touch metal layer may be a sensor metal layer. In this case, the plurality of second touch metals TM2 arranged in the second touch metal layer may be sensor metals forming the touch sensor, and the plurality of first touch metals TM1 arranged in the first touch metal layer may be bridge metals that electrically connect the plurality of second touch metals TM2, which are sensor metals. For example, two or more second touch metals TM2 and at least one first touch metal TM1 may form a single first touch electrode TE1. In this case, two or more second touch metals TM2 may be electrically connected by at least one second touch metal TM2.

Referring to FIG. 4, the touch sensor layer 210 may further include a touch buffer layer 351 disposed on the encapsulation layer 200. The touch buffer layer 351 may be disposed between the encapsulation layer 200 and the touch metal layer. For example, the first touch metal layer may be disposed on the touch buffer layer 351, and the touch interlayer insulating layer 352 may be disposed on the first touch metal layer.

Referring to FIG. 4, the touch sensor layer 210 may further include a touch protection layer 353 disposed to cover the touch metal layer. For example, the touch protection layer 353 may be disposed on the second touch metal layer.

For example, the touch buffer layer 351 may be an inorganic layer including an inorganic insulating material or an organic layer including an organic insulating material. The touch interlayer insulating layer 352 may be an inorganic layer including an inorganic insulating material or an organic layer including an organic insulating material. The touch protection layer 353 may be an inorganic layer including an inorganic insulating material or an organic layer including an organic insulating material.

For example, at least one of the touch buffer layer 351 and the touch interlayer insulating layer 352 may be disposed to extend from the display area DA to the non-display area NDA. The touch protection layer 353 may be disposed to extend from the display area DA to the non-display area NDA.

A touch routing line TL may electrically connect the touch electrode TE to a touch pad TP. The touch routing line TL may be composed of at least one of the first touch metal TM1 and the second touch metal TM2.

For example, the touch routing line TL may be composed of the first touch metal TM1, or it may be composed of the second touch metal TM2, or it may be composed of both the first touch metal TM1 and the second touch metal TM2. When a single touch routing line TL is composed of both the first touch metal TM1 and the second touch metal TM2, the first touch metal TM1 and the second touch metal TM2 forming a single touch routing line TL may be electrically connected through a hole in the touch interlayer insulating layer 352.

For example, a single touch routing line TL may include a plurality of line sections, and each of the plurality of line sections may be either a single line section or a double line section. Here, a single line section refers to a line section with a single signal path, while a double line section refers to a line section in which two signal paths are connected in parallel.

The touch routing line TL may be disposed along the inclined surface of the encapsulation layer 200 and may extend to the touch pad TP while passing over the dam DAM1, DAM2.

The touch buffer layer 351 may have an opening that exposes at least a portion of the touch pad TP. The touch routing line TL may be electrically connected to the touch pad TP through the opening in the touch buffer layer 351. The touch interlayer insulating layer 352 may be disposed on the touch routing line TL and may be disposed to extend to the area where the touch pad TP is disposed. The touch protection layer 353 may be disposed only in the display area DA or may extend to the non-display area NDA to also be disposed on an upper portion of the touch routing line TL. In some cases, the touch protection layer 353 may further extend to an upper portion of the touch pad TP.

Each of the plurality of touch electrodes TE may be a mesh-type electrode having a plurality of openings. In this case, each of the plurality of touch electrodes TE may be composed of at least one second touch metal TM2. However, the present disclosure is not limited thereto.

Referring to FIG. 4, the plurality of first touch metals TM1 and the plurality of second touch metals TM2 may be arranged so as not to overlap with the light-emitting device ED. The plurality of first touch metals TM1 and the plurality of second touch metals TM2 may overlap with the bank 340. Accordingly, the luminous efficiency of the light-emitting device ED may be improved.

Referring to FIG. 4, the touch routing line TL may connect the touch pad TP disposed in the pad area PA within the second non-display area NDA2 to the first touch electrode TE1 disposed in the display area DA. To this end, the touch routing line TL may be disposed across the second non-display area NDA2, the bending area BA, and the first non-display area NDA1.

The touch routing line TL may include a first line section TLa, a second line section TLb, and a third line section TLc. For example, the touch routing line TL may include the first line section TLa and the second line section TLb, which are disposed in the first non-display area NDA1 and the second non-display area NDA2, and the third line section TLc, which is disposed in the bending area BA. The third line section TLc may connect the first line section TLa and the second line section TLb.

The first line section TLa of the touch routing line TL may be a single line section and may further include a third touch metal layer where a third touch metal TM3 is disposed. The first line section TLa of the touch routing line TL may extend along the inclined surface of the encapsulation layer 200 and may extend via at least one dam DAM1 or DAM2. For example, the first line section TLa of the touch routing line TL may be extended to the third line section TLc of the touch routing line TL through at least one of the first touch metal layer and the second touch metal layer.

The second line section TLb of the touch routing line TL may include at least one of a first touch metal TM1 disposed in the first touch metal layer and a second touch metal TM2 disposed in the second touch metal layer. For example, the second line section TLb of the touch routing line TL may be formed using the second touch metal layer. Alternatively, the second line section TLb of the touch routing line TL may be formed by electrically connecting the first touch metal layer and the second touch metal layer.

For example, the second line section TLb of the touch routing line TL may be electrically connected to the touch pad TP through a contact hole that penetrates the second planarization layer 332, the touch buffer layer 351, and the touch interlayer insulating layer 352. The third line section TLc of the touch routing line TL may be connected to the second line section TLb of the touch routing line TL.

The third line section TLc of the touch routing line TL may include a metal layer different from the first to third touch metal layers, where the first to third touch metals TM1, TM2, and TM3 are disposed. For example, the metal layer included in the third line section TLc of the touch routing line TL may be the same as a metal layer where electrodes or lines for display driving are disposed. For example, the metal layer included in the third line section TLc of the touch routing line TL may include a metal layer where the pixel electrode PE is disposed, but is not limited thereto.

The touch pad TP may be electrically connected to the second line section TLb of the touch routing line TL and may include a metal layer different from the first to third touch metal layers. For example, the metal layer included in the touch pad TP may be the same as a metal layer where electrodes or lines for display driving are disposed. The metal layer included in the touch pad TP may include a metal layer where the pixel electrode PE is disposed, but is not limited thereto.

Referring to FIG. 4, the display panel 110 of the display device 100 according to embodiments of the present disclosure may further include a common voltage line VSSL to which a common voltage VSS is applied and a connection pattern CP that connects the common electrode CE and the common voltage line VSSL. For example, the connection pattern CP may include the same material as the pixel electrode PE. The connection pattern CP may include a first connection pattern CP1 and a second connection pattern CP2. The first connection pattern CP1 may connect the common electrode CE to the second connection pattern CP2, and the second connection pattern CP2 may connect the first connection pattern CP1 to the common voltage line VSSL, but is not limited thereto.

Meanwhile, referring to FIG. 3, a first portion 500 of the non-display area NDA can be observed. Hereinafter, the first portion 500 of the non-display area NDA will be described in detail.

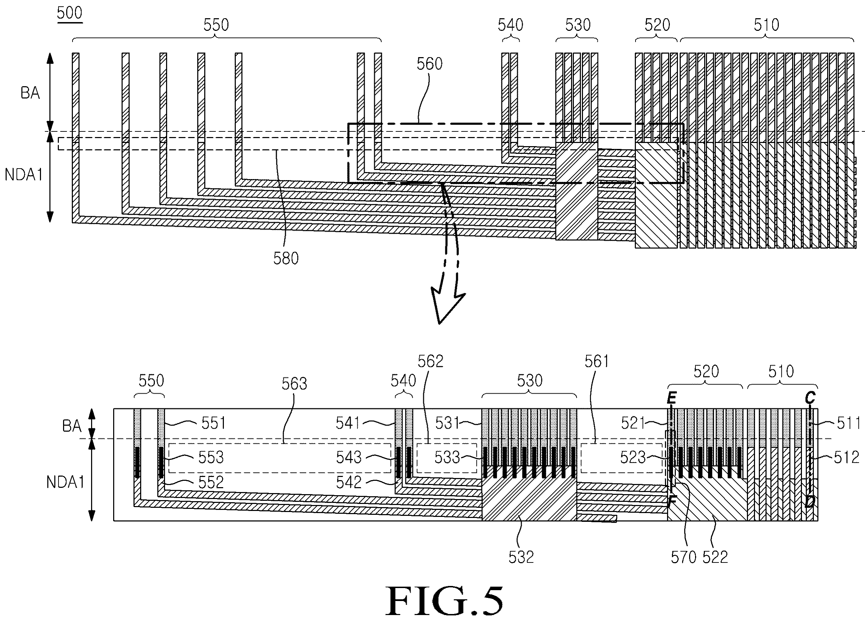

FIG. 5 is an enlarged view of the first portion 500 of the non-display area NDA shown in FIG. 3.

Referring to FIG. 5, a plurality of lines 510 to 550 may be disposed in the bending area BA and the first non-display area NDA1.

The plurality of lines 510 to 550 may include a first-type line 510, a second-type line 520, a third-type line 530, a fourth-type line 540, and a fifth-type line 550.

The first-type line 510 may be a line positioned closest to the outer edge of the non-display area NDA. The first-type line 510 may extend from the bending area BA to the first non-display area NDA1. The first-type line 510 may be a line that transmits various signals. For example, the first-type line 510 may be a line for transmitting a touch driving signal and a touch sensing signal, but is not limited thereto.

The second-type line 520 may be disposed adjacent to the first-type line 510. For example, the outer edge portion of the first non-display area NDA1 may be positioned to the right of the first-type line 510, and the second-type line 520 may be positioned to the left of the first-type line 510. The second-type line 520 may extend from the bending area BA to the first non-display area NDA1. After extending into the first non-display area NDA1, the second-type line 520 may bend in a rightward direction, which is a third direction DR3. The second-type line 520 may be a line that transmits various signals. For example, the second-type line 520 may be a line for transmitting the driving voltage VDD or the reference voltage VSS shown in FIG. 2, but is not limited thereto.

The third-type line 530 may be disposed adjacent to the second-type line 520. For example, the second-type line 520 may be positioned between the first-type line 510 and the third-type line 530, and the third-type line 530 may be positioned to the left of the second-type line 520. The third-type line 530 may extend from the bending area BA to the first non-display area NDA1. The third-type line 530 may be a line that transmits various signals. For example, the third-type line 530 may be a line for transmitting the driving voltage VDD or the reference voltage VSS shown in FIG. 2, but is not limited thereto.

The fourth-type line 540 may be disposed adjacent to the third-type line 530. For example, the third-type line 530 may be positioned between the second-type line 520 and the fourth-type line 540, and the fourth-type line 540 may be positioned to the left of the third-type line 530. The fourth-type line 540 may extend from the bending area BA to the first non-display area NDA1. The fourth-type line 540 may extend rightward in the first non-display area NDA1. The fourth-type line 540 may be a line that transmits various signals. For example, the fourth-type line 540 may be a line for transmitting a voltage for driving a gate driving circuit, but is not limited thereto.

The fifth-type line 550 may be disposed adjacent to the fourth-type line 540. For example, the fourth-type line 540 may be positioned between the third-type line 530 and the fifth-type line 550, and the fifth-type line 550 may be positioned to the left of the fourth-type line 540. The fifth-type line 550 may extend from the bending area BA to the first non-display area NDA1. The fifth-type line 550 may extend rightward in the first non-display area NDA1. The fifth-type line 550 may be a line that transmits various signals. For example, the fifth-type line 550 may be a line for transmitting data signals, but is not limited thereto.

Hereinafter, for the convenience of description, the first-type line 510 is defined as the touch routing line 510. The third-type line 530 is defined as the reference voltage line 530. The second-type line 520 is defined as the driving voltage line 520. The fourth-type line 540 is defined as the gate driving line 540. The fifth-type line 550 is defined as the data voltage line 550. These definitions are provided for convenience of description and do not limit the signals supplied to the first-type line 510 to the fifth-type line 550.

Referring to FIG. 5, a second portion 560, which is an area between the first non-display area NDA1 and the bending area BA, can be observed. Referring to FIG. 5, the second portion 560 may be an area where all of the plurality of lines 510, 520, 530, 540, and 550 are depicted. The second portion 560 may overlap with the delamination prevention design area 580, where structures for preventing delamination are arranged. The second portion 560 does not represent a specific component but rather refers to a designated area for ease of description. An enlarged view of the second portion 560 is shown at the bottom of FIG. 5.

Referring to FIG. 5, the touch routing line 510 may include a first touch routing line portion 511 and a second touch routing line portion 512.

The first touch routing line portion 511 may be positioned in the bending area BA and the first non-display area NDA1. The first touch routing line portion 511 may extend from the bending area BA toward the first non-display area NDA1. The first touch routing line portion 511 may extend in a direction opposite to the second direction DR2.

The second touch routing line portion 512 may be positioned in the first non-display area NDA1. The second touch routing line portion 512 may extend in a direction opposite to the second direction DR2 from the first non-display area NDA1.

The second touch routing line portion 512 may be in contact with the first touch routing line portion 511 in the first non-display area NDA1. The second touch routing line portion 512 may be positioned higher than the first touch routing line portion 511 relative to the substrate 111. Accordingly, at the contact point between the first touch routing line portion 511 and the second touch routing line portion 512, the second touch routing line portion 512 may be positioned on the first touch routing line portion 511.

Referring to FIG. 5, the driving voltage line 520 may include a first driving voltage line portion 521, a second driving voltage line portion 522, and a third driving voltage line portion 523.

The first driving voltage line portion 521 may be positioned in the bending area BA and the first non-display area NDA1. The first driving voltage line portion 521 may extend from the bending area BA toward the first non-display area NDA1. The first driving voltage line portion 521 may extend in a direction opposite to the second direction DR2.

The second driving voltage line portion 522 may be positioned in the first non-display area NDA1. The second driving voltage line portion 522 may extend in a direction opposite to the second direction DR2 and then extend in the rightward third direction DR3.

The second driving voltage line portion 522 may have a plate shape. A line structure in the form of a plate may have a greater width than a single-line structure. Referring to FIG. 5, it can be seen that the second driving voltage line portion 522 is in contact with multiple first driving voltage line portions 521. The second driving voltage line portion 522 may be in contact with multiple first driving voltage line portions 521 and the first non-display area NDA1.

The third driving voltage line portion 523 may be positioned on the first driving voltage line portion 521 and the second driving voltage line portion 522. In this case, the third driving voltage line portion 523 may be positioned on the touch buffer layer 351. The specific characteristics of the third driving voltage line portion 523 will be described later.

Referring to FIG. 5, the ground voltage line 530 may include a first ground voltage line portion 531, a second ground voltage line portion 532, and a third ground voltage line portion 533.

The first ground voltage line portion 531 may be positioned in the bending area BA and the first non-display area NDA1. The first ground voltage line portion 531 may extend from the bending area BA toward the first non-display area NDA1. The first ground voltage line portion 531 may extend in a direction opposite to the second direction DR2.

The second ground voltage line portion 532 may be positioned in the first non-display area NDA1. The second ground voltage line portion 532 may extend in a direction opposite to the second direction DR2.

The second ground voltage line portion 532 may have a plate shape. A line structure in the form of a plate may have a greater width than a single-line structure. Referring to FIG. 5, it can be seen that the second ground voltage line portion 532 is in contact with multiple first ground voltage line portions 531. The second ground voltage line portion 532 may be in contact with multiple first ground voltage line portions 531 and the first non-display area NDA1.

The first ground voltage line portion 531 may be positioned higher than the second ground voltage line portion 532 relative to the substrate 111. Accordingly, at the contact point between the first ground voltage line portion 531 and the second ground voltage line portion 532, the first ground voltage line portion 531 may be positioned on the second ground voltage line portion 532.

The third ground voltage line portion 533 may be positioned on the first ground voltage line portion 531 and the second ground voltage line portion 532. In this case, the third ground voltage line portion 533 may be positioned on the touch buffer layer 351. The specific characteristics of the third ground voltage line portion 533 will be described later.

Referring to FIG. 5, the gate driving line 540 may include a first gate driving line portion 541, a second gate driving line portion 542, and a third gate driving line portion 543.

The first gate driving line portion 541 may be positioned in the bending area BA and the first non-display area NDA1. The first gate driving line portion 541 may extend from the bending area BA toward the first non-display area NDA1. The first gate driving line portion 541 may extend in a direction opposite to the second direction DR2.

The second gate driving line portion 542 may be positioned in the first non-display area NDA1. The second gate driving line portion 542 may extend in a direction opposite to the second direction DR2 and then extend downward to the right.

The second gate driving line portion 542 may be in contact with the first gate driving line portion 541 in the first non-display area NDA1. The first gate driving line portion 541 may be positioned higher than the second touch routing line portion 512 relative to the substrate 111. Accordingly, at the contact point between the first gate driving line portion 541 and the second gate driving line portion 542, the first gate driving line portion 541 may be positioned on the second gate driving line portion 542.

The third gate driving line portion 543 may be positioned on the first gate driving line portion 541 and the second gate driving line portion 542. In this case, the third gate driving line portion 543 may be positioned on the touch buffer layer 351. The specific characteristics of the third gate driving line portion 543 will be described later.

Referring to FIG. 5, the data voltage line 550 may include a first data voltage line portion 551, a second data voltage line portion 552, and a third data voltage line portion 553.

The first data voltage line portion 551 may be positioned in the bending area BA and the first non-display area NDA1. The first data voltage line portion 551 may extend from the bending area BA toward the first non-display area NDA1. The first data voltage line portion 551 may extend in a direction opposite to the second direction DR2.

The second data voltage line portion 552 may be positioned in the first non-display area NDA1. The second data voltage line portion 552 may extend in a direction opposite to the second direction DR2 and then extend downward to the right.

The second data voltage line portion 552 may be in contact with the first data voltage line portion 551 in the first non-display area NDA1. The first data voltage line portion 551 may be positioned higher than the second touch routing line portion 512 relative to the substrate 111. Accordingly, at the contact point between the first data voltage line portion 551 and the second data voltage line portion 552, the first data voltage line portion 551 may be positioned on the second data voltage line portion 552.

The third data voltage line portion 553 may be positioned on the first data voltage line portion 551 and the second data voltage line portion 552. In this case, the third data voltage line portion 553 may be positioned on the touch buffer layer 351. The specific characteristics of the third data voltage line portion 553 will be described later.

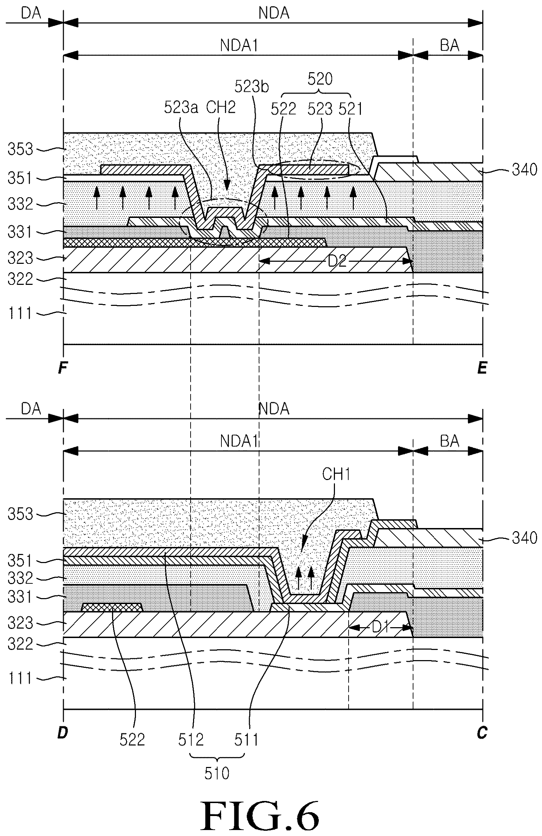

Referring to FIG. 5, the C-D region and the E-F region can be observed. The cross-sectional views of the C-D region and the E-F region will be described together with reference to FIG. 6.

FIG. 6 is a cross-sectional view of the C-D region and the E-F region shown in FIG. 5.

Referring to FIG. 6, the second gate insulation layer 322 may be disposed on the substrate 111. The second gate insulation layer 322 may be disposed in the first non-display area NDA1 and the bending area BA. The characteristics of the second gate insulation layer 322 shown in FIG. 6 may be the same as those of the second gate insulation layer 322 shown in FIG. 4, and a repeated description is omitted.

Referring to FIG. 6, the second interlayer insulation layer 323 may be disposed only up to the first non-display area NDA1. Since the bending area BA is a region where the display panel 110 is bent, only the minimum required layers may be disposed. Referring to FIG. 6, the bending area BA may include the substrate 111, the first planarization layer 331, the second planarization layer 332, the bank 340, and lines including the second source-drain metal (511, 522, 532, 541, 551). The characteristics of the second interlayer insulation layer 323 shown in FIG. 6 may be the same as those of the second interlayer insulation layer 323 shown in FIG. 4, and a repeated description is omitted.

Referring to FIG. 6, the second planarization layer 332 may be disposed on the first planarization layer 331. The bank 340 may be disposed on the second planarization layer 332, and the bank 340 may be positioned at the boundary between the first non-display area NDA1 and the bending area BA. The second planarization layer 332 may have a touch buffer layer 351 and a touch protection layer 353 disposed thereon. A line including a metal material may be disposed between the touch buffer layer 351 and the touch protection layer 353. The characteristics of the second planarization layer 332 shown in FIG. 6 may be the same as those of the second planarization layer 332 shown in FIG. 4, and a repeated description is omitted.

Referring to FIG. 6, the first planarization layer 331 may be disposed on the second interlayer insulation layer 323. The first planarization layer 331 may include a plurality of contact holes CH1. The plurality of contact holes CH1 may refer to etched regions of the first planarization layer 331 for exposing the upper surface of the second interlayer insulation layer 323. The characteristics of the first planarization layer 331 shown in FIG. 6 may be the same as those of the first planarization layer 331 shown in FIG. 4, and a repeated description is omitted.

The plurality of insulation layers 331, 332, and 351 may include contact holes CH1. However, the contact holes CH1 may not be included in the plurality of insulation layers 331, 332, and 351 and may be considered as separate components. For example, the contact holes CH1 may refer to the etched regions of the plurality of insulation layers 331, 332, and 351. Hereinafter, the contact holes CH1 may be described as being included in the plurality of insulation layers 331, 332, and 351, or they may be considered as separate components.

Referring to the cross-sectional view of the C-D region in FIG. 6, the first touch routing line portion 511 may be disposed on the first planarization layer 331 and the second interlayer insulation layer 323. The first touch routing line portion 511 may be disposed in contact with the second interlayer insulation layer 323 in the first non-display area NDA1. The first touch routing line portion 511 may extend toward the bending area BA from the contact point with the second interlayer insulation layer 323. In this case, the first touch routing line portion 511 may ascend along the side portion of the first planarization layer 331. The first touch routing line portion 511 may include the first source-drain metal and may be disposed within the first source-drain metal layer. The material included in the first touch routing line portion 511 shown in FIG. 6 may be the same as the material included in the first source-drain metal layer shown in FIG. 4.

Referring to the cross-sectional view of the C-D region in FIG. 6, the second planarization layer 332 may be disposed to cover the first touch routing line portion 511. The second planarization layer 332 may include a contact hole CH1, which may serve as a connection point for electrically connecting the first touch routing line portion 511 to the second touch routing line portion 512.

Referring to the cross-sectional view of the C-D region in FIG. 6, the touch buffer layer 351 may be disposed on the second planarization layer 332. The touch buffer layer 351 may be positioned within the contact hole CH1 of the second planarization layer 332. In this case, a portion of the touch buffer layer 351 in contact with the first touch routing line portion 511 may be etched and removed. As a result of the etching and removal of a portion of the touch buffer layer 351, the first touch routing line portion 511 may be electrically connected to the second touch routing line portion 512. The touch buffer layer 351 may be positioned on the second planarization layer 332 and the bank 340. The touch buffer layer 351 may be positioned within the first non-display area NDA1. For example, the touch buffer layer 351 may have been uniformly deposited over the entire display panel 110, with unnecessary portions later etched and removed.

Referring to the cross-sectional view of the C-D region in FIG. 6, the second touch routing line portion 512 may be disposed on the touch buffer layer 351. The second touch routing line portion 512 may be positioned within the first non-display area NDA1. The second touch routing line portion 512 may also be disposed around the etched portion CH1 of the touch buffer layer 351. The second touch routing line portion 512 may come into contact with the first touch routing line portion 511 at the etched portion CH1 of the touch buffer layer 351. As the first touch routing line portion 511 and the second touch routing line portion 512 are electrically connected, the touch routing line 510 may transmit touch-related signals. The second touch routing line portion 512 shown in FIG. 6 may include the same material as the first touch metal layer shown in FIG. 4.

Referring to FIG. 5 and FIG. 6, the second driving voltage line portion 522 is positioned closer to the substrate 111 than the second touch routing line portion 512. Accordingly, it can be seen that the second driving voltage line portion 522 is positioned below the second touch routing line portion 512. Referring to FIG. 6, the second driving voltage line portion 522 may be disposed on the second interlayer insulation layer 323, and the second touch routing line portion 512 may be positioned on the second driving voltage line portion 522.

Referring to the cross-sectional view of the E-F region in FIG. 6, the second driving voltage line portion 522 may be disposed on the second interlayer insulation layer 323. The second driving voltage line portion 522 may be positioned in the first non-display area NDA1. The second driving voltage line portion 522 may include the same material as that included in the first source-drain metal layer.

Referring to the cross-sectional view of the E-F region in FIG. 6, the first planarization layer 331 may be disposed on the second driving voltage line portion 522. The first planarization layer 331 may be positioned in the first non-display area NDA1 and the bending area BA. The first planarization layer 331 may include multiple contact holes CH2, and in the cross-sectional view shown in FIG. 6, two contact holes CH2 can be observed.

Referring to the cross-sectional view of the E-F region in FIG. 6, the first driving voltage line portion 521 may be disposed on the first planarization layer 331. The first driving voltage line portion 521 may extend from the first non-display area NDA1 into the bending area BA. The first driving voltage line portion 521 may be in contact with the second driving voltage line portion 522 in the first non-display area NDA1. Through the contact hole CH2 of the first planarization layer 331, the first driving voltage line portion 521 may be in contact with the second driving voltage line portion 522. Referring to the cross-sectional view in FIG. 6, the cross-section of the first driving voltage line portion 521 may be arranged in a "W" shape. The first driving voltage line portion 521 may include the same material as that contained in the second source-drain metal layer.

Referring to the cross-sectional view of the E-F region in FIG. 6, the second planarization layer 332 may be disposed on the first driving voltage line portion 521. The second planarization layer 332 may include a contact hole CH2. Through the contact hole CH2 of the second planarization layer 332, the upper surface of the first driving voltage line portion 521 may be connected to other components.

Referring to the cross-sectional view of the E-F region in FIG. 6, the bank 340 and the touch buffer layer 351 may be disposed on the second planarization layer 332. The bank 340 may be positioned in the first non-display area NDA1 and the bending area BA, while the touch buffer layer 351 may be positioned in the first non-display area NDA1. A portion of the touch buffer layer 351 may be etched and removed, and within the etched and removed region CH2, line that includes a metal material may be disposed.

Referring to the cross-sectional view of the E-F region in FIG. 6, the driving voltage line 520 may further include the third driving voltage line portion 523. The touch protection layer 353 may be disposed on the touch buffer layer 351, and the third driving voltage line portion 523 may be positioned between the touch protection layer 353 and the touch buffer layer 351. The third driving voltage line portion 523 may be in contact with the second driving voltage line portion 522 at the etched and removed region CH2 of the touch buffer layer 351. When viewed from the cross-sectional perspective of FIG. 6, since the first planarization layer 331 contains two contact holes CH2, the third driving voltage line portion 523 may be arranged in a "W" shape. The third driving voltage line portion 523 shown in FIG. 6 may include the same material as the second touch metal layer shown in FIG. 4.

Referring to the cross-sectional view of the E-F region in FIG. 6, a portion 532a of the third driving voltage line portion 523 may be disposed in contact with the second driving voltage line portion 522. Another portion 523b of the third driving voltage line portion 523 may be disposed on and in contact with the touch buffer layer 351.

Referring to the cross-sectional view of the E-F region in FIG. 6, a portion of the third driving voltage line portion 523 may be disposed on the touch buffer layer 351. If the touch buffer layer 351 is exposed to specific environmental conditions or a long period has passed since its fabrication, the touch buffer layer 351 may become detached from the second planarization layer 332 and the bank 340. This phenomenon may be referred to as touch buffer layer delamination. If touch buffer layer delamination occurs, not only does the touch buffer layer 351 become detached from the second planarization layer 332, but also the connection of other components disposed on the touch buffer layer 351 may be severed.

Referring to the cross-sectional view of the C-D region in FIG. 6, if the touch buffer layer 351 delaminates from the second planarization layer 332, the first touch routing line portion 511 may become physically separated from the second touch routing line portion 512. This occurs because, as the touch buffer layer 351 delaminates, the second touch routing line portion 512 disposed on the touch buffer layer 351 separates from the first touch routing line portion 511. However, referring to the cross-sectional view of the E-F region in FIG. 6, the third driving voltage line portion 523 is disposed on the touch buffer layer 351 and is also physically in contact with the second driving voltage line portion 522. The third driving voltage line portion 523 may be firmly coupled to the second driving voltage line portion 522, thereby securing the touch buffer layer 351 below it to prevent delamination.

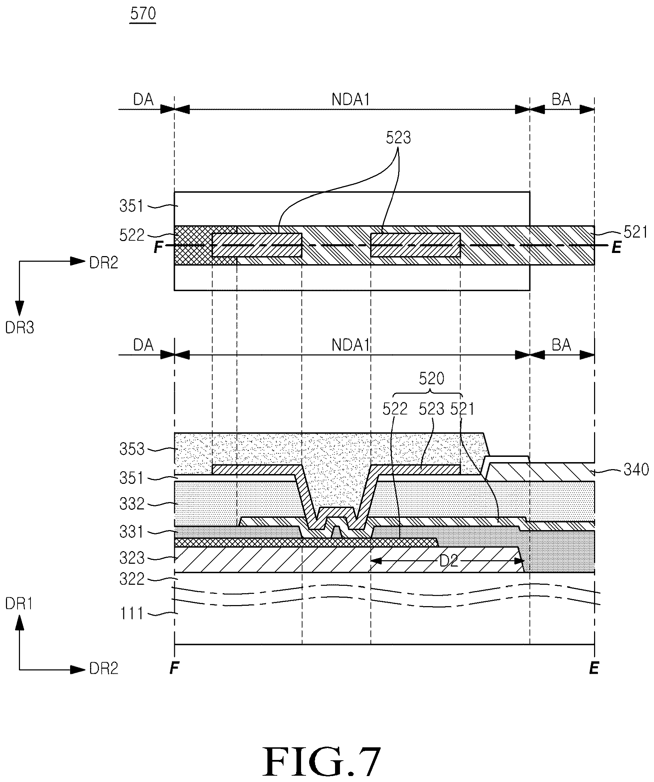

The wider the left and right width of the third driving voltage line portion 523 or the larger the contact area between the third driving voltage line portion 523 and the touch buffer layer 351, the more effectively the touch buffer layer 351 may be prevented from delaminating. Referring to FIG. 7, the upper surface of the third driving voltage line portion 523 can be observed.

FIG. 7 is a plan view of the third portion 570 of FIG. 5.

Referring to FIG. 7, the cross-sectional view of the E-F region can be observed. This is the same as the cross-sectional view of the E-F region shown in FIG. 6.

Referring to FIG. 7, the plan view corresponding to the E-F region can be observed. In FIG. 7, a dotted line is depicted in the corresponding area between the cross-sectional view and the plan view of the E-F region.

Referring to FIG. 5, the first non-display area NDA1 may include the third portion 570.

Referring to FIG. 7, the third driving voltage line portion 523 may be disposed in the third portion 570.

Referring to the plan view of FIG. 7, the first driving voltage line portion 521 and the second driving voltage line portion 522 can be observed. The first driving voltage line portion 521 and the second driving voltage line portion 522 may be disposed below the touch buffer layer 351.

Referring to the plan view of FIG. 7, the vertical width of the touch buffer layer 351 may be greater than the vertical width of the first driving voltage line portion 521 and the second driving voltage line portion 522.

Referring to the plan view of FIG. 7, the touch buffer layer 351 may be positioned in the first non-display area NDA1.

Referring to the plan view of FIG. 7, the third driving voltage line portion 523 may be disposed on a portion of the touch buffer layer 351. Since the third driving voltage line portion 523 is disposed on the touch buffer layer 351, it may prevent delamination of the touch buffer layer 351.

The arrangement of the third driving voltage line portion 523 on the touch buffer layer 351 may be defined as a delamination prevention reinforcement design. Accordingly, the third portion 570 of the first non-display area NDA1 corresponds to the delamination prevention reinforcement design. Referring to FIG. 5, the delamination prevention design area 580 for implementing the delamination prevention reinforcement design can be observed.

The delamination prevention design area 580 may include structures for delamination prevention reinforcement design and structures for auxiliary reinforcement design.

The structure for the delamination prevention reinforcement design may be positioned in the area where the lines 520 to 550 are disposed. For example, the third portion 570 shown in FIG. 5 may be an exemplary area where the structure for the delamination prevention reinforcement design is arranged.

The structure for the auxiliary reinforcement design may be positioned in the areas between each of the lines 520 to 550. For example, the auxiliary reinforcement design areas 561, 562, and 563 shown in FIG. 5 may be areas where the structure for the auxiliary reinforcement design is arranged.

Hereinafter, a more detailed explanation will be provided regarding the structures related to the delamination prevention design area 580.

The base voltage line 530 shown in FIG. 5 may also include the same structure as the third driving voltage line portion 523, and its corresponding structure, the third base voltage line portion 533, may be disposed on the touch buffer layer 351.

The gate driving line 540 shown in FIG. 5 may also include the same structure as the third driving voltage line portion 523, and its corresponding structure, the third gate driving line portion 543, may be disposed on the touch buffer layer 351. The first gate driving line portion 541 of the gate driving line 540 may include the material contained in the second source-drain metal layer shown in FIG. 4. The second gate driving line portion 542 of the gate driving line 540 may include the material contained in either the first gate metal layer or the second gate metal layer shown in FIG. 4. Since the first gate metal layer and the second gate metal layer are positioned closer to the substrate 111 than the first source-drain metal layer, the first gate metal layer and the second gate metal layer may extend through the lower region of the first source-drain metal layer. Accordingly, referring to FIG. 5, the second gate driving line portion 542 can be observed extending through the lower portion of the base voltage line 530, the lower portion of the driving voltage line 520, and the lower portion of the touch routing line 510.

Referring to FIG. 5, the data voltage line 550 may also include the same structure as the third driving voltage line portion 523, and its corresponding structure, the third data voltage line portion 553, may be disposed on the touch buffer layer 351. The first data voltage line portion 551 of the data voltage line 550 may include the material contained in the second source-drain metal layer shown in FIG. 4. The second data voltage line portion 552 of the data voltage line 550 may include the material contained in either the first gate metal layer or the second gate metal layer shown in FIG. 4. Since the first gate metal layer and the second gate metal layer are positioned closer to the substrate 111 than the first source-drain metal layer, the first gate metal layer and the second gate metal layer may extend through the lower region of the first source-drain metal layer. Accordingly, referring to FIG. 5, the second data voltage line portion 552 can be observed extending through the lower portion of the base voltage line 530, the lower portion of the driving voltage line 520, and the lower portion of the touch routing line 510.

Referring to FIG. 5, auxiliary reinforcement design areas 561, 562, and 563 may be positioned in the first non-display area NDA1. The auxiliary reinforcement design area is an area where structures are arranged to further enhance the delamination prevention reinforcement design. The plurality of auxiliary reinforcement design areas 561, 562, and 563 may be positioned between the first type line 510 and the fourth type line 540. For example, the first auxiliary reinforcement design area 561 may be positioned between the driving voltage line 520 and the base voltage line 530. The second auxiliary reinforcement design area 562 may be positioned between the base voltage line 530 and the gate driving line 540. The third auxiliary reinforcement design area 563 may be positioned between the gate driving line 540 and the data voltage line 550.

Hereinafter, the auxiliary reinforcement design area will be explained using the first auxiliary reinforcement design area 561 as an example.

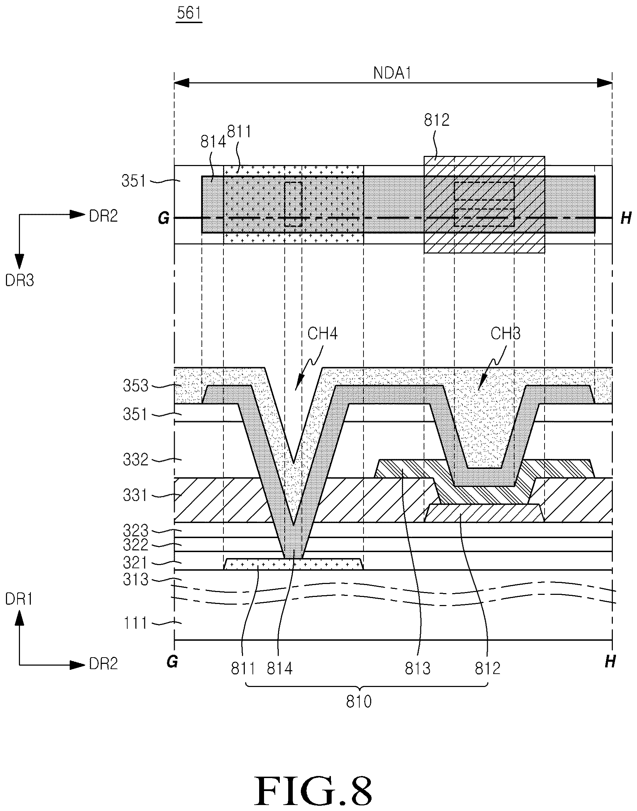

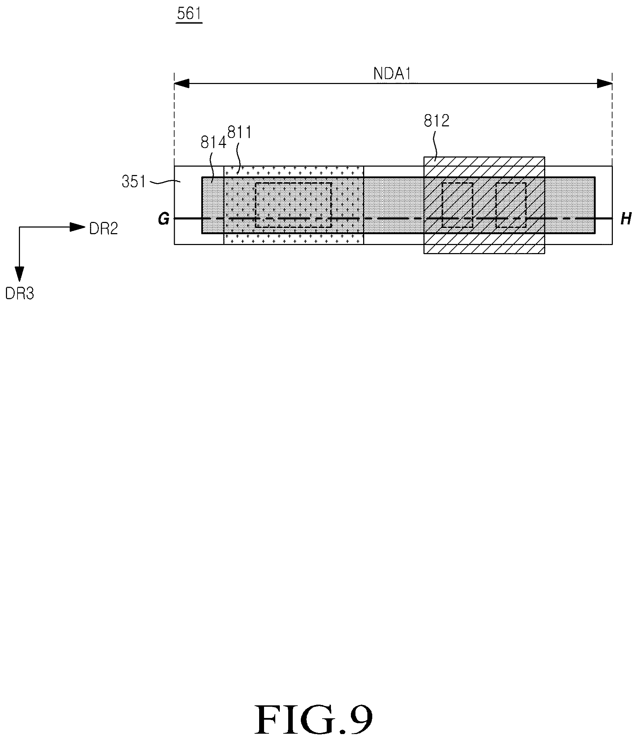

FIG. 8 and FIG. 9 are a plan view and a cross-sectional view of the first auxiliary reinforcement design area 561 shown in FIG. 5.

Referring to FIG. 8, the reinforcement metal 810 may include a first reinforcement metal portion 811, a second reinforcement metal portion 812, a third reinforcement metal portion 813, and a fourth reinforcement metal portion 814.

Referring to FIG. 8, the first interlayer insulating layer 313 may be disposed on the substrate 111. The characteristics of the first interlayer insulating layer 313 may be the same as those of the first interlayer insulating layer 313 shown in FIG. 4.

Referring to FIG. 8, the first reinforcement metal portion 811 may be disposed on the first interlayer insulating layer 313. The first reinforcement metal portion 811 may include the material contained in the second shield pattern BSM2 shown in FIG. 4. While the first reinforcement metal portion 811 is illustrated as being disposed on the first interlayer insulating layer 313, it may also be positioned on the lower buffer layer 311a of FIG. 4. In this case, the first reinforcement metal portion 811 may include the material contained in the first shield pattern BSM1 shown in FIG. 4.

Referring to FIG. 8, the second buffer layer 321 may be disposed on the first interlayer insulating layer 313. The second gate insulating layer 322 may be disposed on the second buffer layer 321, and the second interlayer insulating layer 323 may be disposed on the second gate insulating layer 322. The characteristics of the second buffer layer 321, the second gate insulating layer 322, and the second interlayer insulating layer 323 may be the same as those of the second buffer layer 321, the second gate insulating layer 322, and the second interlayer insulating layer 323 shown in FIG. 4.

Referring to FIG. 8, the second reinforcement metal portion 812 may be disposed on the second interlayer insulating layer 323. The second reinforcement metal portion 812 may be positioned in the first non-display area NDA1. The second reinforcement metal portion 812 may include the material contained in the first source-drain metal layer shown in FIG. 4.

Referring to FIG. 8, the first planarization layer 331 may be disposed on the second interlayer insulating layer 323. The first planarization layer 331 may be disposed on the second reinforcement metal portion 812. The first planarization layer 331 may include a contact hole CH3, and the upper surface of the second reinforcement metal portion 812 may be covered by the first planarization layer 331 but exposed through the contact hole CH3.

Referring to FIG. 8, the third reinforcement metal portion 813 may be disposed on the first planarization layer 331. The third reinforcement metal portion 813 may be in contact with the second reinforcement metal portion 812 through the contact hole CH3 of the first planarization layer 331. The third reinforcement metal portion 813 may include the same material as that contained in the second source-drain metal layer shown in FIG. 4.

Referring to FIG. 8, the second planarization layer 332 may be disposed on the first planarization layer 331. The second planarization layer 332 may include a contact hole CH3, and the upper surface of the third reinforcement metal portion 813 covered by the second planarization layer 332, may be exposed through the contact hole CH3.

Referring to FIG. 8, the touch buffer layer 351 may be disposed on the second planarization layer 332. A portion of the upper surface of the touch buffer layer 351 may be etched and removed, and in this process, portions of the insulating layers 321, 322, 323, 331, and 332 disposed beneath the touch buffer layer 351 may also be etched and removed. As a result, portions of the upper surfaces of the first reinforcement metal portion 811 and the third reinforcement metal portion 813 may be exposed.

Referring to FIG. 8, the fourth reinforcement metal portion 814 may be disposed on the touch buffer layer 351. The fourth reinforcement metal portion 814 may be in contact with the first reinforcement metal portion 811 through the etched and removed areas CH4 of the insulating layers 321, 322, 323, 331, 332, and 351. Additionally, the fourth reinforcement metal portion 814 may be in contact with the third reinforcement metal portion 813 through the etched and removed areas CH3 of the insulating layers 331, 332, and 351. The fourth reinforcement metal portion 814 may include the same material as that contained in the second touch metal shown in FIG. 4. The touch protection layer 353 may be disposed on the fourth reinforcement metal portion 814.

Referring to FIG. 8, the fourth reinforcement metal portion 814 may be disposed on the touch buffer layer 351. Since the fourth reinforcement metal portion 814 is disposed on the touch buffer layer 351, it may prevent the touch buffer layer 351 from delaminating from the second planarization layer 332.

Referring to FIG. 8, because the fourth reinforcement metal portion 814 is in contact with both the first reinforcement metal portion 811 and the third reinforcement metal portion 813, its position may be maintained more securely. Referring to FIG. 8 and FIG. 9, if the contact area between the fourth reinforcement metal portion 814 and the first reinforcement metal portion 811 is increased, the position of the fourth reinforcement metal portion 814 may be maintained more securely. Referring to FIG. 9, it can be seen that the fourth reinforcement metal portion 814 is designed to have a larger contact area with the first reinforcement metal portion 811. Additionally, it can be seen that the fourth reinforcement metal portion 814 is designed to have a larger contact area with the third reinforcement metal portion 813. Referring to FIG. 9, the number of contact surfaces between the fourth reinforcement metal portion 814 and the third reinforcement metal portion 813 may be increased, thereby further securing the position of the fourth reinforcement metal portion 814.

The above-described content can be summarized as follows. The touch buffer layer may be disposed on the second planarization layer. If the adhesion between the touch buffer layer and the second planarization layer is weak, the touch buffer layer may detach from the second planarization layer. This phenomenon may be referred to as delamination of touch buffer layer. In such cases, the components disposed on the touch buffer layer may also be separated from the second planarization layer along with the touch buffer layer.

Meanwhile, a plurality of lines may extend from the bending area to the non-display area. Each of these lines may include materials from multiple metal layers. For example, each of the plurality of lines may selectively include materials from the first shield metal, the second shield metal, the gate metal, the first source-drain metal, the second source-drain metal, the first touch metal, and the second touch metal.

Depending on the design, the plurality of lines may deliver signals related to touch, driving voltage, base voltage, data voltage, and signals for driving the gate driving circuit. For example, the touch routing line may be disposed at the outermost part of the non-display area and may be positioned at the left and right ends of the non-display area. Between the touch routing lines disposed on the left and right, the data voltage line, the gate driving line, the driving voltage line, and the base voltage line may be disposed.

The touch routing line may include a connection area between a line made of the second source-drain metal layer material and a line of the second touch metal layer material. In this case, the touch buffer layer may be positioned between the second source-drain metal layer and the second touch metal layer. Accordingly, if delamination occurs in the touch buffer layer, the connection between the line of the second source-drain metal layer material and the line of the second touch metal layer material may be broken. In other words, the touch routing line may be in an open state or become disconnected.

Other lines may include connection portions between a line of the first source-drain metal layer material and a line of the second source-drain metal layer material. Since the touch buffer layer is disposed on the second source-drain metal layer, even if the touch buffer layer delaminates, other lines may remain intact. In this case, since other lines do not use the second touch metal, the second touch metal may be additionally disposed on the touch buffer layer.

Other lines may further include reinforcement design lines disposed on the touch buffer layer. The reinforcement design lines may press the touch buffer layer while also being coupled to the line made of the second source-drain metal layer material. Accordingly, the touch buffer layer may be stably secured.

The reinforcement design lines may be disposed on lines where signals can be transmitted. Additionally, the reinforcement design lines may be disposed between other lines.

The embodiments of this specification may prevent delamination of the touch buffer layer by connecting the metal disposed on the buffer layer with the metal disposed beneath the buffer layer.

The embodiments of this specification may prevent signal line disconnection by connecting the metal disposed on the buffer layer with the metal disposed beneath the buffer layer.

The embodiments of this specification may reduce the repair process and optimize manufacturing by connecting the metal disposed on the buffer layer with the metal disposed beneath the buffer layer.

A display device according to the embodiments of this specification may be described as follows.

The embodiments of the present disclosure relate to a display device comprising: a substrate having a display area, a first non-display area outside the display area, and a bending area positioned on one side of the first non-display area; a first power line portion disposed on the substrate and extending from the first non-display area to the display area; a first insulating layer disposed on the first power line portion and positioned in the first non-display area; a second power line portion disposed on the first insulating layer and electrically connected to the first power line portion through a hole in the first insulating layer, wherein the second power line portion extends from the first non-display area to the bending area; a second insulating layer disposed on the second power line portion; a buffer layer disposed on the second insulating layer and positioned in the first non-display area; and a third power line portion disposed on the buffer layer and positioned in the first non-display area, wherein the third power line portion is electrically connected to the second power line portion through holes in the buffer layer and the second insulating layer.

The third power line portion may be disposed in contact with the second power line portion through the holes in the buffer layer and the second insulating layer.

The third power line portion may be positioned on the side of the second insulating layer within the holes in the buffer layer and the second insulating layer. Additionally, the third power line portion may extend from the side of the second insulating layer to the upper surface of the buffer layer and come into contact with the buffer layer.

The third power line portion may be disposed to cover the buffer layer portion positioned around the holes in the buffer layer and the second insulating layer.

The third power line portion may be positioned only in the first non-display area without extending to the display area or the bending area.

The third power line portion may be electrically connected to the first power line portion and the second power line portion, and the first power line portion may transmit signals to the second power line portion.

The third power line portion may be electrically connected to the second power line portion through two or more holes in the first insulating layer.

The third power line portion may include a contact portion having a W-shape.

The display device may further include: a first touch routing line portion disposed on the substrate and extending from the first non-display area to the bending area; and a second touch routing line portion disposed on the buffer layer and extending from the first non-display area to the display area.

The third power line portion may include the same material as that contained in the second touch routing line portion. The second touch routing line may be in contact with the buffer layer while also being in contact with the first touch routing line. The third power line portion may be in contact with the buffer layer while also being in contact with the second power line portion.

The display device may further include: a first reinforcement metal disposed on the substrate, positioned only in the first non-display area, and adjacent to the bending area; a second reinforcement metal disposed on the substrate, positioned only in the first non-display area, and positioned higher than the first reinforcement metal from the substrate; a third reinforcement metal disposed on the first insulating layer and positioned in contact with the second reinforcement metal; and a fourth reinforcement metal positioned in contact with the first reinforcement metal and the third reinforcement metal while also being disposed in contact with a portion of the upper surface of the buffer layer.

The fourth reinforcement metal may extend from the contact point with a portion of the upper surface of the buffer layer to the contact point with the first reinforcement metal. The fourth reinforcement metal may further extend from another contact point with the upper surface of the buffer layer to the contact point with the third reinforcement metal.

The fourth reinforcement metal may be in contact with the third power line portion at two or more points.

The first to fourth reinforcement metals may not receive an electrical signal.

The first reinforcement metal may include a material different from that of the second reinforcement metal. The second reinforcement metal may include the same material as that contained in the first power line portion. The third reinforcement metal may include the same material as that contained in the second power line portion. The fourth reinforcement metal may include the same material as that contained in the third power line portion.

The display device may further include: a light-emitting device disposed between the second insulating layer and the buffer layer; and touch metal disposed on the buffer layer and overlapping the light-emitting device. Additionally, the third power line portion may include the same material as that contained in the touch metal.

The display device may further include: a transistor disposed on the substrate, including a gate electrode, a drain electrode, and a source electrode; and the transistor electrically connected to the light-emitting device. Additionally, the second power line portion may include a material different from that contained in the first power line portion.

The first power line portion may include the same material as that contained in the drain electrode or the source electrode of the transistor.

The first power line portion may supply a base voltage to the light-emitting device or a driving voltage to the transistor.

The first power line portion may include the same material as that contained in the gate electrode of the transistor.

In some embodiments, a display device may include a substrate having a display area, a first non-display area adjacent to the display area, and a bending area disposed on one side of the first non-display area. A first conductive line may be disposed on the substrate and may extend from the first non-display area into the display area. A first insulating layer may be disposed on the first conductive line, and a first opening (or also referred to as 'a first hole') may be defined in the first insulating layer. A second conductive line may be disposed on the first insulating layer and may be electrically connected to the first conductive line through the first opening, with the second conductive line extending from the first non-display area toward the bending area. A second insulating layer may be disposed on the second conductive line. A buffer layer may be disposed on the second insulating layer. A second opening (or also referred to as 'a second hole') may be defined through the buffer layer and the second insulating layer. A third conductive line may be disposed on the buffer layer in the first non-display area and may be electrically connected to the second conductive line through the second opening. The third conductive line may cover at least a portion of the buffer layer surrounding the second opening.

In some embodiments, in a plan view, the third conductive line overlaps the second conductive line at the second opening. In a cross-sectional view taken through the second opening, the first conductive line, the second conductive line, and the third conductive line are vertically stacked in that order from the substrate upward. The third conductive line may extend laterally beyond a perimeter of the second opening to cover a surrounding region of the buffer layer in a plan view. The third conductive line may also be wider than the second opening in a plan view.

In certain configurations, the buffer layer may be disposed only in the first non-display area and may not extend into the display area or the bending area. The third conductive line may be disposed on an upper surface of the buffer layer in a cross-sectional view, while the second conductive line may be disposed below the buffer layer. The third conductive line may also include a contact geometry having a W-shaped profile in cross-section, defined by alternating upward and downward portions that form three valleys and two peaks.

In some embodiments, the display device may further include a clamp structure disposed in the first non-display area, the clamp structure including a plurality of reinforcement metals. The clamp structure, including the plurality of reinforcement metals, may be configured to mechanically restrain the buffer layer against delamination. The clamp structure may include a first reinforcement metal disposed on the substrate in the first non-display area, a second reinforcement metal disposed above the first reinforcement metal relative to the substrate, and a third reinforcement metal disposed on the first insulating layer and in contact with the second reinforcement metal. The clamp structure may further include a fourth reinforcement metal disposed partially on an upper surface of the buffer layer and in contact with the first reinforcement metal and the third reinforcement metal.

The clamp structure may be configured such that the first reinforcement metal, the second reinforcement metal, the third reinforcement metal, and the fourth reinforcement metal are not electrically connected to any conductive line that carries operating signals. The first reinforcement metal may be composed of a material different from the second reinforcement metal. The second reinforcement metal may include the same material as the first conductive line, the third reinforcement metal may include the same material as the second conductive line, and the fourth reinforcement metal may include the same material as the third conductive line. This arrangement of reinforcement metals allows the clamp structure to mechanically stabilize the buffer layer while permitting fabrication in coordination with the deposition of existing conductive lines.

Furthermore, the present disclosure addresses reliability issues in flexible and foldable display devices by introducing a structure in which a metal disposed on a buffer layer is electrically connected to a metal disposed below the buffer layer. This arrangement prevents delamination of the touch buffer layer and avoids disconnection of signal lines. The structure enhances mechanical reliability during bending or folding, improves durability of the display, and simplifies the manufacturing process by reducing the need for repair and rework.

The present disclosure also provides routing strategies for critical lines such as touch routing lines, driving voltage lines, ground lines, and gate lines across bending areas of the substrate. These lines are divided into multiple portions, with selected portions disposed on the buffer layer for added stability. In combination with crack prevention patterns, this arrangement ensures stable electrical connectivity during repeated flexing, enabling accurate signal transmission and maintaining high quality image display.

## Claims

1. A display device (100) comprising:
a substrate (111) including a display area (DA), a first non-display area (NDA1) outside the display area (DA), and a bending area (BA) positioned on one side of the first non-display area (NDA1);
a first power line portion(522) disposed on the substrate (111) and extending from the first non-display area (NDA1) to the display area (DA);
a first insulating layer(331) disposed on the first power line portion(522) and positioned in the first non-display area (NDA1);
a second power line portion(521) disposed on the first insulating layer(331), electrically connected to the first power line portion(522) through a hole(CH2) in the first insulating layer(331), and extending from the first non-display area (NDA1) to the bending area (BA);
a second insulating layer(332) disposed on the second power line portion(521);
a buffer layer(351) disposed on the second insulating layer(332) and positioned in the first non-display area (NDA1); and
a third power line portion(523) positioned in the first non-display area (NDA1), disposed on the buffer layer(351), and electrically connected to the second power line portion(521) through holes in the buffer layer(351) and the second insulating layer(332).

2. The display device (100) according to claim 1, wherein the third power line portion(523) is disposed in contact with the second power line portion(521) in the hole(CH2) of the buffer layer(351) and the second insulating layer(332).

3. The display device (100) according to claim 2, wherein the third power line portion(523) is positioned on the side portion of the second insulating layer(332) in the hole(CH2) of the buffer layer(351) and the second insulating layer(332), and extends from the side of the second insulating layer(332) to the upper surface of the buffer layer(351) to make contact with the buffer layer(351), and/or
wherein the third power line portion(523) is disposed to cover a portion of the buffer layer(351) positioned around the hole(CH2) in the buffer layer(351) and the second insulating layer(332).

4. The display device (100) according to any of claims 1 to 3, wherein the third power line portion(523) is positioned only in the first non-display area (NDA1) and does not extend to the display area (DA) or the bending area (BA).

5. The display device (100) according to any of claims 1 to 4, wherein the third power line portion(523) is electrically connected to the first power line portion(522) and the second power line portion(521), and the first power line portion(522) is configured to transmit signals to the second power line portion(521).

6. The display device (100) according to any of claims 1 to 5, wherein the third power line portion(523) is electrically connected to the second power line portion(521) through at least two hole(CH2) in the first insulating layer(331).

7. The display device (100) according to any of claims 1 to 6, wherein the third power line portion(523) includes a contact portion having a W-shaped structure.

8. The display device (100) according to any of claims 1 to 7, further comprising:
a first touch routing line portion (511) disposed on the substrate (111) and extending from the first non-display area (NDA1) to the bending area (BA); and
a second touch routing line portion (512) disposed on the buffer layer(351) and extending from the first non-display area (NDA1) to the display area (DA),
wherein, preferably:
the third power line portion(523) includes a material contained in the second touch routing line portion (511),
the second touch routing line portion (512) is in contact with the buffer layer(351) and the first touch routing line portion (511), and
the third power line portion(523) is in contact with the buffer layer(351) and the second power line portion(521).

9. The display device (100) according to any of claims 1 to 8, further comprising:
a first reinforcement metal portion (811) disposed on the substrate (111), positioned only in the first non-display area (NDA1), and positioned adjacent to the bending area (BA);
a second reinforcement metal portion (812) disposed on the substrate (111), positioned only in the first non-display area (NDA1), and positioned higher than the first reinforcement metal relative to the substrate (111);
a third reinforcement metal portion (813) disposed on the first insulating layer(331) and positioned in contact with the second reinforcement metal; and
a fourth reinforcement metal portion (814) positioned in contact with the first and third reinforcement metal portions (811, 813) and disposed partially in contact with a portion of the upper surface of the buffer layer(351).

10. The display device (100) according to claim 9, wherein the fourth reinforcement metal portion (814) extends to a contact point with the first reinforcement metal portion (811) after contacting a portion of the upper surface of the buffer layer(351), and extends to a contact point with the third reinforcement metal portion (813) after contacting another portion of the upper surface of the buffer layer(351).

11. The display device (100) according to claim 9 or 10, wherein the fourth reinforcement metal portion (814) is in contact with the third power line portion(523) at at least two points, and/or wherein the first to fourth reinforcement metal portions (811, ..., 814) do not receive electrical signals.

12. The display device (100) according to any of claims 9 to 11,
wherein the first reinforcement metal portion (811) includes a material different from that of the second reinforcement metal portion (812);
wherein the second reinforcement metal portion (812) includes the same material as the first power line portion(522);
wherein the third reinforcement metal portion (813) includes the same material as the second power line portion(521); and
wherein the fourth reinforcement metal portion (814) includes the same material as the third power line portion(523).

13. The display device (100) according to any of claims 1 to 12, further comprising:
a light-emitting device (ED) disposed between the second insulating layer(332) and the buffer layer(351); and
a touch metal (TM1, TM2) disposed on the buffer layer(351) and overlapping the light-emitting device (ED),
wherein the third power line portion(523) includes the same material as the touch metal (TM1, TM2).

14. The display device (100) according to claim 13, further comprising a transistor (TFT2) disposed on the substrate (111), including a gate electrode (E2a), a drain electrode (E2c), and a source electrode (E2b), and electrically connected to the light-emitting device (ED),
wherein the second power line portion(521) includes a material different from that of the first power line portion(522),
wherein, preferably, the first power line portion(522) includes the same material as the material contained in the drain or source electrode (E2c, E2b) of the transistor (TFT2),
wherein, further preferably, the first power line portion(522) supplies a reference voltage to the light-emitting device (ED) or a driving voltage to the transistor (TFT2).

15. The display device (100) according to claim 14, wherein the first power line portion(522) includes the same material as the material contained in the gate electrode (E2a) of the transistor (TFT2).
